(19) Europäisches Patentamt
European Patent Office
Office européen des brevets

(11) **EP 3 599 477 B1**

(12) **EUROPÄISCHE PATENTSCHRIFT**

(45) Veröffentlichungstag und Bekanntmachung des Hinweises auf die Patenterteilung:
**25.09.2024 Patentblatt 2024/39**

(21) Anmeldenummer: **18185777.2**

(22) Anmeldetag: **26.07.2018**

(51) Internationale Patentklassifikation (IPC):
**G01R 33/567** *(2006.01)* **G01R 33/28** *(2006.01)*

(52) Gemeinsame Patentklassifikation (CPC):
**G01R 33/5676;** G01R 33/288

(54) **VERFAHREN ZUM GETRIGGERTEN AKQUIRIEREN EINES MESSDATENSATZES MITTELS EINER MAGNETRESONANZANLAGE, COMPUTERPROGRAMM, DATENSPEICHER UND MAGNETRESONANZANLAGE**

METHOD FOR TRIGGERED ACQUISITION OF A MEASUREMENT DATA SET BY MEANS OF A MAGNETIC RESONANCE SYSTEM, COMPUTER PROGRAM, DATA STORAGE AND MAGNETIC RESONANCE SYSTEM

PROCÉDÉ D'ACQUISITION DÉCLENCHÉE D'UN ENSEMBLE DE DONNÉES DE MESURE AU MOYEN D'UNE INSTALLATION DE RÉSONANCE MAGNÉTIQUE, PROGRAMME INFORMATIQUE, MÉMOIRE DE DONNÉES ET INSTALLATION DE RÉSONANCE MAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**29.01.2020 Patentblatt 2020/05**

(73) Patentinhaber: **Siemens Healthineers AG 91301 Forchheim (DE)**

(72) Erfinder: **Stemmer, Alto 91054 Erlangen (DE)**

(74) Vertreter: **Siemens Healthineers Patent Attorneys Postfach 22 16 34 80506 München (DE)**

(56) Entgegenhaltungen:
DE-A1- 102009 055 960    DE-A1- 102016 208 094
DE-B3- 102009 061 198

**Beschreibung**

Die Erfindung betrifft ein Verfahren zum getriggerten Akquirieren eines Messdatensatzes eines Zielobjekts in mehreren Einzelmessungen mittels einer Magnetresonanzanlage. Weiter betrifft die Erfindung ein entsprechendes Computerprogramm oder Computerprogrammprodukt, einen Datenspeicher für eine Magnetresonanzanlage mit einem derartigen Computerprogramm und eine Magnetresonanzanlage mit einem derartigen Datenspeicher.

Bei einem getriggerten Akquirieren von Messdaten, also einem getriggerten Messen oder einem getriggerten Betrieb einer Magnetresonanzanlage wird nicht kontinuierlich gemessen, also Messdaten aufgenommen oder erfasst, sondern nur jeweils nachdem bestimmte Bedingungen (Trigger-Bedingungen) erfüllt sind oder ein bestimmtes Ereignis (Trigger-Ereignis) eingetreten ist. Hierdurch wird dann das Messen, also ein jeweiliges Erfassen von Messdaten, getriggert, also ausgelöst oder veranlasst. Ein typischer Anwendungsfall hierfür ist es beispielsweise, das Akquirieren von Messdaten mit einer Atmung eines Patienten zu synchronisieren.

Die Druckschrift DE 102016208094 A1 offenbart eine getriggerte Ausführung einer Bildgebungssequenz, wobei ein zeitlicher Mindestabstand zu einem folgenden Trigger sichergestellt wird. Ferner offenbart die Patentschrift DE 102009061198 B3 ein Verfahren zur getriggerten Durchführung einer Magnetresonanz-Messung, wobei zur Triggerung ein Bezugspunkt in einer Bewegungsphase einer Bewegung, auf die getriggert wird, verwendet wird. Die Druckschrift DE 102009055960 A1 offenbart ein Verfahren zur getriggerten Akquisition von Magnetresonanz-Messdaten, wobei der Trigger mittels eines ausgewerteten Atemsignals gebildet wird.

Aufgabe der vorliegenden Erfindung ist es, eine verbesserte Bildqualität bei gleichzeitig besonders einfacher Nutzbarkeit für eine getriggert Datenakquisition zu ermöglichen. Diese Aufgabe wird erfindungsgemäß durch die Gegenstände der unabhängigen Patentansprüche gelöst. Vorteilhafte Ausgestaltungen und Weiterbildungen der vorliegenden Erfindung sind in den abhängigen Patentansprüchen, in der Beschreibung und in den Zeichnungen angegeben.

Ein erfindungsgemäßes Verfahren dient zum getriggerten Akquirieren eines Messdatensatzes eines Zielobjekts in mehreren Einzelmessungen mittels einer Magnetresonanzanlage, also beispielswese mittels eines Magnetresonanztomographen (MRT). Unter einer Einzelmessung ist im Sinne der vorliegenden Erfindung dabei nicht notwendigerweise ein Akquirieren oder Erfassen eines einzigen Datenpunktes oder Messwertes zu verstehen. Vielmehr stellt eine Einzelmessung in diesem Sinne einen zeitlich ununterbrochenen Abschnitt des Akquirierens des gesamten Messdatensatzes dar. Es können also während einer Einzelmessung beispielsweise mehrere Messwerte erfasst oder aufgenommen, also akquiriert werden beispielsweise eine vollständige Schicht des Zielobjekts. Zwischen zwei Einzelmessungen kann dann eine Zeitspanne vergehen, während der keine Daten für den Messdatensatz akquiriert werden.

Das Zielobjekt kann dabei bevorzugt ein Patient oder ein bestimmter Gewebebereich sein, ohne jedoch im Sinne der vorliegenden Erfindung hierauf beschränkt zu sein.

Bei dem erfindungsgemäßen Verfahren wird ein zyklisches Signal erfasst, welches eine zyklische Veränderung des Zielobjekts oder eines Teils des Zielobjekts beschreibt. Die zyklische Veränderung kann insbesondere eine sich wiederholende Bewegung des Zielobjekts oder eines Teils des Zielobjekts sein. Das zyklische Signal beziehungsweise die zyklische Veränderung kann mittels der Magnetresonanzanlage selbst, beispielsweise durch eine MR-Navigatorsequenz, oder durch eine spezifisch hierfür vorgesehene Erfassungseinrichtung erfasst werden. Die Erfassungseinrichtung kann beispielsweise einen pneumatischen Sensor, einen Brustgurt, einen elektromagnetischen Sensor und/oder dergleichen umfassen. Weiter werden bei dem erfindungsgemäßen Verfahren fortgesetzt, also auch während folgender Schritte des Verfahrens, automatisch Zyklen des zyklischen Signals erkannt. Dazu kann das erfasste zyklische Signal mit einer entsprechenden Datenverarbeitungseinrichtung automatisch verarbeitet, also analysiert oder ausgewertet werden.

Es wird dann in einem weiteren Verfahrensschritt des erfindungsgemäßen Verfahrens automatisch wenigstens eine Eigenschaft des zyklischen Signals bestimmt. Diese Eigenschaft ist eine mittlere Dauer der erkannten Zyklen in Relation zu einer Referenzzeitdauer als einem vorgegebenen Referenzwert eines Akquisitionsparameters. Dies wird weiter unten im Zusammenhang mit Weiterbildungen und Ausgestaltungen des Verfahrens näher erläutert.

In einem weiteren Verfahrensschritt des erfindungsgemäßen Verfahrens wird automatisch festgelegt, ob in einem bestimmten erkannten Zyklus des zyklischen Signals ein Triggern einer der Einzelmessungen zugelassen wird, in Abhängigkeit von der mittleren Dauer der erkannten Zyklen und der Referenzzeitdauer. Die Referenzzeitdauer ist für das Akquirieren des Messdatensatzes vorgegeben.

Dabei kann die Referenzzeitdauer beispielsweise als Vergleichswert oder als Berechnungsgrundlage dienen, muss also nicht notwendigerweise ein unmittelbar während einer der Einzelmessungen durch die Magnetresonanzanlage für das eigentliche Akquirieren von Messdaten, also die eigentlichen Messungen, verwendeter Parameter oder Parameterwert sein. Wie weiter unten näher erläutert wird, kann die Referenzzeitdauer also beispielsweise eine Referenzrepetitionszeit oder Protokoll-Repetitionszeit sein, für das Akquirieren des Messdatensatzes kann dann letztlich aber eine davon abweichende Repetitionszeit verwendet werden. Die tatsächlich verwendete Repetitionszeit kann dann aber beispielsweise in einem bestimmten Verhältnis zu der Referenzrepetitionszeit stehen, beispielsweise wenigstens genauso lang sein.

Es kann also beispielsweise ein bestimmtes Muster oder eine bestimmte Vorschrift bestimmt oder festgelegt werden, gemäß welcher sich für jeden, insbesondere auch zukünftigen, Zyklus des zyklischen Signals ermitteln lässt, ob in dem jeweiligen Zyklus das Triggern jeweils einer der Einzelmessungen zugelassen wird. Ebenso kann aber für jeden erkannten Zyklus individuell, beispielsweise zur Laufzeit, also während der jeweilige Zyklus des zyklischen Signals erfasst oder gemessen wird, festgelegt werden, ob in diesem jeweiligen Zyklus eine der Einzelmessungen getriggert werden kann oder darf.

Dass das Triggern einer der Einzelmessungen zugelassen ist, stellt eine notwendige Bedingung dafür dar, dass in dem jeweiligen Zyklus tatsächlich eine der Einzelmessungen durchgeführt wird, also entsprechende Magnetresonanz-Daten (MR-Daten, MR-Messdaten) für den Messdatensatz erfasst oder aufgenommen werden. Es können insbesondere jedoch einige oder mehrere weitere Bedingungen oder Ereignisse vorgegeben sein, um in einem Zyklus, in dem das Triggern einer der Einzelmessungen zugelassen ist, tatsächlich eine der Einzelmessungen zu triggern, also auszulösen. Ist in einem bestimmten Zyklus also das Triggern einer der Einzelmessungen nicht zugelassen, so wird unabhängig davon, ob diese weiteren Bedingungen oder Ereignisse erfüllt beziehungsweise aufgetreten sind, keine der Einzelmessungen durchgeführt, der jeweilige Zyklus also ausgelassen.

Die Referenzzeitdauer gibt eine minimale Zeitspanne an, die jeweils zwischen zwei aufeinanderfolgenden Einzelmessungen beziehungsweise zugehörigen Triggern oder Trigger-Ereignissen liegen muss. Diese Referenzzeit kann also die bereits genannte Protokoll-Repetitionszeit sein, welche durch ein Protokoll festgelegt ist. Ein solches Protokoll kann beispielsweise für das Akquirieren des Messdatensatzes oder als Ausgangseinstellung hierfür ausgewählt und gegebenenfalls angepasst werden. Ein weiterer Akquisitionsparameter kann ein maximaler SAR-Wert (SAR: spezifische Absorptionsrate, englisch: "Specific Absorption Rate") sein, der in wenigstens einem Zeitintervall einer bestimmten vorgegebenen Länge bei dem Akquirieren des Messdatensatzes oder bei einer gesamten Messung oder Untersuchung des Zielobjekts jeweils nicht überschritten werden darf. Dies wird ebenfalls weiter unten im Zusammenhang mit entsprechenden Ausgestaltungen und Weiterbildungen des Verfahrens näher erläutert.

Als Teil des erfindungsgemäßen Verfahrens wird die mittlere Dauer $L_m$, also eine mittlere zeitliche Länge, der erkannten Zyklen des zyklischen Signals bestimmt. Die mittlere Dauer $L_m$ ist also eine mittlere Zyklus- oder Periodendauer des zyklischen Signals. Als der Referenzwert beziehungsweise als der Akquisitionsparameter wird dann eine Referenzrepetitionszeit oder Referenzzeitdauer $TR_{prot}$ vorgegeben. Weiter wird dann die kleinste ganze positive Zahl $n \geq 1$ bestimmt, sodass ein n-faches der bestimmten mittleren Dauer $L_m$ länger ist als die vorgegebene Referenzrepetitionszeit $TR_{prot}$. Das Triggern der Einzelmessungen wird dann nur in jedem n-ten Zyklus des zyklischen Signals zugelassen. Ist die vorgegebene Repetitionszeit $TR_{prot}$ klein gegenüber der mittleren Dauer $L_m$, so wird n zu 1 bestimmt und es kann in jedem Zyklus, also während jeder Periode, des zyklischen Signals, eine der Einzelmessungen getriggert werden.

Andernfalls, wenn also beispielsweise die vorgegebene Referenzzeit oder Referenzrepetitionszeit $TR_{prot}$ ähnlich groß oder größer als die mittlere Dauer $L_m$ ist, kann n zu >1 bestimmt werden. Eine der Einzelmessungen kann dann nur in jedem n-ten Zyklus, also beispielsweise in jedem zweiten oder dritten oder vierten Zyklus des zyklischen Signals getriggert werden, auch wenn die übrigen notwendigen Bedingungen zum Auslösen einer der Einzelmessungen in jedem Zyklus des zyklischen Signals zumindest jeweils einmal erfüllt sind. Somit können dann zwischen Zyklen, in denen eine der Einzelmessungen ausgelöst oder durchgeführt wird, ein oder mehrere Zyklen ausgelassen werden, also vergehen, während derer keine der Einzelmessungen ausgelöst wird.

Hierdurch kann sich zwar eine insgesamt zum Akquirieren des vollständigen Messdatensatzes benötigte Zeit verlängern, es wird jedoch sichergestellt, dass jede der Einzelmessungen zu einem optimalen Zeitpunkt oder während einer optimalen Phase des zyklischen Signals durchgeführt werden kann. Zudem wird sichergestellt, dass eine sich ergebende effektive, also tatsächliche, Repetitionszeit $TR_{eff}$ während des Akquirierens des Messdatensatzes konstant und gleichmäßig ist, abgesehen von unvermeidbaren, beispielsweise physiologisch bedingten, Variationen der Dauer der Zyklen des zyklischen Signals. Ist das zyklische Signal beispielsweise eine Atemkurve eines Patienten, so unterliegt die Dauer der Zyklen, also die Zyklusdauer oder Periodenlänge, einer unvermeidlichen natürlichen Variation, wobei aber sichergestellt werden kann, dass zwischen jeder der Einzelmessungen die gleiche Anzahl von Atemzyklen liegt und jede Einzelmessung beispielsweise in einer jeweils besonders geeigneten, insbesondere einer bestimmten vorgegebenen, Phase, beispielsweise am Ende eines Ausatmens, und nicht verzögert durchgeführt wird -etwa aufgrund einer ungünstigen Interaktion zwischen der vorgegebenen Referenzrepetitionszeit $TR_{prot}$ und der Zykluslänge.

Letzteres kann beispielsweise dann der Fall sein, wenn bei einem herkömmlichen getriggerten Verfahren die dort vorgegebene Referenzrepetitionszeit um einen Bruchteil länger ist als die mittlere Länge des Atemzyklus und sich diese Abweichung dann über mehrere Zyklen aufsummiert, sodass in - aufgrund der Varianz der Zykluslängen unregelmäßigen - Abständen ein Atemzyklus ausgelassen wird oder beispielsweise aufgrund einer Trägheit beim Erkennen einer jeweiligen Phase des Zyklus eine Einzelmessung verspätet gestartet wird, beispielsweise zu Beginn des nächsten Atemzyklus, also wenn der Patient bereits wieder einatmet.

Zum Bestimmen der mittleren Dauer $L_m$ kann bevorzugt eine Lernphase vorgesehen sein, während derer über mehrere Zyklen hinweg lediglich das zyklische Signal erfasst, aber keine Messdaten für den Messdatensatz aufgenommen werden. Die mittlere Dauer $L_m$ kann dann einmalig anhand der während dieser Lernphase erfassten Zyklen bestimmt werden. Im Folgenden, also während des anschließend fortgesetzten Erfassens des zyklischen Signals und während der Einzelmessungen, also während des Akquirierens der Messdaten für den Messdatensatz, können die Zyklen des zyklischen Signals dann automatisch durchgezählt oder nummeriert werden, um jeweils das Triggern einer der Einzelmessungen entsprechend dem bestimmten Wert von n zuzulassen oder zu verhindern. Durch das so insgesamt ermöglichte zeitlich gleichmäßige Triggern der Einzelmessungen ergibt sich letztlich eine verbesserte Daten- oder Bildqualität des Messdatensatzes.

Bei bisherigen, bekannten getriggerten Messverfahren kann es zu verzögerten Auslösungen, also zu sogenannten Fehltriggern, kommen, insbesondere wenn die Referenzzeit eine Referenzrepetitionszeit für die Messung und ähnlich lang oder groß ist wie eine Zykluslänge oder Zyklusdauer des zyklischen Signals. Demgegenüber ermöglicht die vorliegende Erfindung eine getriggerte Messung oder Datenakquisition, welche robust gegenüber solchen Szenarien ist. Ist beispielsweise in einem bestimmten Zyklus keine Einzelmessung zugelassen, so erfolgt während dieses Zyklus auch dann keine Einzelmessung, wenn alle übrigen notwendigen Bedingungen oder Trigger erfüllt beziehungsweise gegeben sind, sondern die nächste Einzelmessung kann frühestens erst wieder im nächsten Zyklus, insbesondere nachdem dieser oder dessen Beginn eindeutig erkannt worden ist, erfolgen. Dadurch werden verzögerte Auslösungen von Einzelmessungen vermieden. Zu einer verzögerten Auslösung einer Einzelmessung kann es in den bisher bekannten getriggerten Messverfahren beispielsweise kommen, wenn die übrigen notwendigen Trigger-Bedingungen erfüllt sind bevor die genannte Referenzzeit seit dem letzten Trigger, also der letzten Einzelmessung vergangen ist.

Durch die vorliegende Erfindung kann vorteilhaft also vermieden werden, dass die Einzelmessungen zu verzögerten, also nicht optimalen Zeitpunkten oder Phasen des zyklischen Signals gestartet werden. Durch die vorliegende Erfindung kann also vorteilhaft zuverlässig sichergestellt werden, dass die Einzelmessungen stets zu einem optimalen Zeitpunkt gestartet werden. Dieser optimale Zeitpunkt kann vorgegeben oder durch die übrigen notwendigen Bedingungen in vorgegebener Weise bestimmt sein. Insgesamt wird durch die vorliegende Erfindung somit eine verbesserte Konsistenz der Messdaten des Messdatensatzes und somit letztlich eine verbesserte Daten- oder Bildqualität erreicht beziehungsweise ermöglicht. Aufgrund der durch die vorliegende Erfindung erreichten Robustheit kann vorteilhaft beispielsweise die Referenzrepetitionszeit einer vorgegebenen Messsequenz größer gewählt oder vorgegeben werden als bisher. Insbesondere kann diese Referenzrepetitionszeit vorgefertigter Akquisitions-Parametersätze, also Protokolle, beispielsweise gleich oder nur geringfügig kürzer als eine typische Atemfrequenz oder Atemperiode eines typischen Patienten sein, ohne hierdurch die Bildqualität nachteilig zu beeinflussen. Zudem kann so eine letztlich unnötige Limitierung anderer Sequenz- oder Protokollparameter vermieden werden.

Durch ein Durchführen der Einzelmessungen kann der Messdatensatz akquiriert werden. Aus dem Messdatensatz können beispielsweise eine oder mehrere Magnetresonanzabbildungen berechnet, insbesondere rekonstruiert, werden. Die eine oder mehrere Magnetresonanzabbildungen können beispielsweise einem Benutzer angezeigt werden, z.B. auf einem Bildschirm.

Bei bisherigen getriggerten Messverfahren ist demgegenüber die Referenzzeit oder Referenzrepetitionszeit oftmals sehr viel kürzer als beispielsweise die typische Atemperiode, gewählt, um Fehltrigger zu vermeiden, was jedoch dazu führen kann, dass auf Basis dieser unnötig kurzen Referenzrepetitionszeit automatisch ermittelt wird, dass Sequenz- oder Protokollparameter wie beispielsweise ein Flipwinkel oder eine Zahl abzubildender Schichten des Zielobjekts reduziert werden müssen, was letztlich ebenfalls zu einer verschlechterten Bildqualität und/oder zu einer verringerten Effizienz der Messung führt.

Zudem wird durch die vorliegende Erfindung eine Robustheit gegenüber Anwenderfehlern oder einem mangelnden Verständnis auf Seiten des jeweiligen Anwenders verbessert. Wird beispielsweise im Rahmen einer SAR-Simulation oder SAR-Vorausberechnung festgestellt, dass während einer geplanten Messung ein maximaler SAR-Wert voraussichtlich überschritten wird, so kann einem Anwender vorgeschlagen werden, die Referenzrepetitionszeit für die Messung zu verlängern. Folgt der Anwender diesem Vorschlag und verlängert die Referenzrepetitionszeit beispielsweise bis über die Zykluslänge, also eine mittlere Periodendauer des zyklischen Signals hinaus, so kann dies in herkömmlichen Verfahren zu den genannten Verzögerungen oder Fehltriggern führen. Dabei kann im Allgemeinen nicht davon ausgegangen werden, dass dem jeweiligen Anwender notwendigerweise ein Zusammenhang zwischen der Referenzrepetitionszeit, dadurch bedingten Fehltriggern und einer resultierenden Bildqualität bekannt ist. Durch die vorliegende Erfindung wird auch in solchen Szenarien eine bestmögliche Bildqualität zuverlässig sichergestellt.

In vorteilhafter Ausgestaltung der vorliegenden Erfindung wird als notwendige Bedingung zum Triggern der Einzelmessungen ein Zykluspunkt festgelegt, den das zyklische Signal in einem Zyklus jeweils erreicht haben muss. Der Zykluspunkt kann also in jedem Zyklus einen Trigger-Zeitpunkt zum Auslösen einer der Einzelmessungen darstellen oder angeben. Hierdurch kann vorteilhaft also sichergestellt werden, dass jede der Einzelmessungen an einander entsprechenden Punkten, also Zykluspunkten oder -phasen, des zyklischen Signals ausgelöst oder gestartet werden. Es kann beispielsweise als der Zykluspunkt ein bestimmter Wert des zyklischen Signals vorgegeben sein, den das zyklische Signal aus einer vorgegebenen Richtung, also beispielsweise von unten ansteigend, erreicht oder überschritten haben muss, um eine der Einzelmessungen zu triggern. Hierbei handelt es sich jedoch um eine notwendige und nicht um eine alleinig hinreichende Bedingung zum Triggern einer der Einzelmessungen, da dazu in dem jeweiligen Zyklus dieses Triggern zunächst zugelassen sein muss. Je nach Anwendungsfall kann der Zykluspunkt ebenso beispielsweise ein Wendepunkt oder ein Umkehrpunkt, also beispielsweise ein lokaler Extremwert des zyklischen Signals sein. Ebenso kann der Zykluspunkt beispielsweise ein vorgegebenes Zeitintervall sein oder durch ein vorgegebenes Zeitintervall bestimmt sein, das seit einem solchen Wende- oder Umkehrpunkt oder Extremwert des zyklischen Signals vergangen ist oder sein muss.

Ebenso kann ein zweiter Zykluspunkt vorgegeben sein, den das zyklische Signal als notwendige Bedingung zum Triggern einer der Einzelmessungen in dem jeweiligen Zyklus noch nicht erreicht oder überschritten haben darf. Dies kann beispielsweise ein Endwert, ein Umkehrpunkt oder ein typischer, durchschnittlicher oder erwarteter Maximalwert sein. Durch diese beiden Zykluspunkt kann also ein Bereich oder Fenster, also ein Abschnitt eines jeden Zyklus des zyklischen Signals definiert werden, in dem sich das zyklische Signal oder ein Wert des zyklischen Signals als notwendige Bedingung zum Triggern einer der Einzelmessungen jeweils befinden muss.

In vorteilhafter Weiterbildung der vorliegenden Erfindung wird die empirische Standardabweichung $\sigma$ der Dauern der erkannten Zyklen des zyklischen Signals bestimmt. Die Zahl n wird dann so bestimmt, dass die Bedingung

$$(n \cdot L_m - x \cdot \sigma) > TR_{prot} \qquad (1)$$

erfüllt ist, wobei x ein freier Parameter mit einem vorgegebenen Wert ist. x kann dabei ganzzahlige oder nicht ganzzahlige Werte haben. Durch den freien Parameter x kann eine Empfindlichkeit des Verfahrens eingestellt werden. Ein Wert des freien Parameters x kann also von einem jeweiligen Anwender je nach Bedarf oder Anwendungsfall eingestellt oder vorgegeben sein. In bevorzugter Weiterbildung der vorliegenden Erfindung wird der Wert des freien Parameters x aus dem Intervall 0,5 bis 2, besonders bevorzugt aus dem Intervall 0,5 bis 1, vorgegeben. Diese Intervalle können dabei geschlossen sein. Es hat sich erwiesen, dass besonders gute Ergebnisse erzielt werden können, wenn der Wert von x in diesen Intervallen liegt. Durch das Berücksichtigen der Standardabweichung $\sigma$ kann eine Robustheit des Verfahrens weiter verbessert und somit besonders zuverlässig sichergestellt werden, dass die Einzelmessungen tatsächlich in einem gleichmäßigen Abstand, also regelmäßig alle n Zyklen, durchgeführt werden. Gegenüber einer entsprechenden Verwendung eines vorgegebenen festen Wertes bietet die Verwendung der Standardabweichung den Vorteil, individuelle Eigenschaften des jeweiligen Zielobjekts zu berücksichtigen. Es kann also beispielsweise berücksichtigt werden, ob ein jeweiliger Patient eine relativ gleichmäßige oder ungleichmäßige Atemfrequenz hat. Dadurch kann die verbesserte Robustheit bei einer gleichzeitig insgesamt minimalen Zeit zum Akquirieren des Messdatensatzes erreicht werden.

In weiterer vorteilhafter Weiterbildung der vorliegenden Erfindung werden die erkannten Zyklen des zyklischen Signals mit einer fortlaufenden Zyklusnummer k durchnummeriert. Jedem erfassten Messwert s des zyklischen Signals wird dann eine der Zyklusnummern k zugeordnet. Mit anderen Worten wird also für jeden erfassten Messwert s bestimmt, in welchem Zyklus der jeweilige Messwert erfasst wurde. Das Zuordnen kann beispielsweise in Form eines Index erfolgen, sodass also ein Messwert $s_k$ im Zyklus k erfasst worden ist. Für jeden der erkannten, nummerierten Zyklen wird dann ein Maximalwert des zyklischen Signals in diesem Zyklus bestimmt und daraus eine Folge dieser Maximalwerte erzeugt. Der Maximalwert kann dabei ein größter Wert oder ein Endwert, also ein zuletzt in dem jeweiligen Zyklus erfasster Wert, sein. Dazu kann jeder der Messwerte s als Tupel aus einem Signalwert und einem Zeitstempel erfasst werden. Als Dauer eines Zyklus k kann dann jeweils ein zeitlicher Abstand zwischen dem Maximalwert des Zyklus k und dem Maximalwert des unmittelbar vorausgegangenen Zyklus k-1 festgelegt oder berechnet werden. Die Dauer eines Zyklus kann dann also dem zeitlichen Abstand zweier aufeinanderfolgender Maximalwerte entsprechen. Aus der Folge der Maximalwerte können dann also die Größen $L_m$ und $\sigma$ der Bedingung (1) bestimmt werden. Die Verwendung der Maximalwerte kann dies besonders einfach, genau und zuverlässig ermöglichen. Zudem kann so besonders einfach, zuverlässig und konsistent das gleichmäßige Triggern der Einzelmessungen in jedem n-ten Zyklus ermöglicht werden. Die Maximalwerte können auch einen jeweiligen Anfang beziehungsweise ein jeweiliges Ende der Zyklen definieren.

Die mittlere Dauer $L_m$ der erkannten Zyklen kann als Mittelwert, also als arithmetisches Mittel, oder als Median bestimmt werden. Es werden beispielsweise zu jedem Signalpunkt oder Messwert s des zyklischen Signals ein Signalwert und ein zugehöriger Zeitstempel erfasst und ein Atemintervall oder Zyklus k zugeordnet und zusätzlich zu jedem abgeschlossenen Atemintervall oder Zyklus k ein Maximalwert $s_{max}$ bestimmt.

Ist das zyklische Signal eine Atemkurve, so kann der Maximalwert des Zyklus k bevorzugt einem Zustand maximalen Einatmens während dieses Zyklus k entsprechen. Dies ist besonders vorteilhaft, da ein dieses maximale Einatmen anzeigender Einatmungs-Peak in dem zyklischen Signal typischerweise spitzer oder steiler ist als eine entsprechende Signalform bei einem maximalen Ausatmen, also ein Ausatmungs-Peak, sodass die jeweilige Dauer der Zyklen, also Atemintervalle, vorteilhaft besonders genau und konsistent bestimmt werden kann. Es ergibt sich somit eine Folge von Tupeln $(s_k, t_k)$, aus einem Signalwert $s_k$ und einem zugehörigen Zeitstempel $t_k$, für die Maximal der Zyklen k. Werden beispielsweise während der Lernphase insgesamt K Atemintervalle gezählt, dann können die mittlere Dauer $L_m$ als arithmetischer Mittelwert über K-1 vollständige Atemintervalle und die zugehörige empirische Standardabweichung $\sigma$ bestimmt werden als:

$$L_m = \overline{dt} = \frac{1}{K-1} \sum_{k=2}^{K} (t_k - t_{k-1}) \qquad (2)$$

$$\sigma = \sqrt{\frac{1}{K-1} \sum_{k=2}^{K} ((t_k - t_{k-1}) - \overline{dt})} \qquad (3).$$

Soll stattdessen die mittlere Dauer $L_m$ als Median bestimmt werden, so werden die K-1 Dauern

$$dt_k = (t_k - t_{k-1}), \quad k = 2, \ldots, K$$

in aufsteigender Reihenfolge geordnet, wodurch sich eine neue Folge die $\widetilde{dt_k}$ ergibt mit $\widetilde{dt_i} \leq \widetilde{dt_j}$ für i < j. Es sei dann

$$dt_{median} = \begin{cases} \widetilde{dt}_{\frac{K}{2}+1} & , \text{für } K \text{ gerade} \\ \frac{1}{2}\left(\widetilde{dt}_{\frac{K+1}{2}+1} + \widetilde{dt}_{\frac{K+1}{2}}\right) & , \text{für } K \text{ ungerade} \end{cases} \qquad (4)$$

und

$$\widetilde{\sigma} = \sqrt{\frac{1}{K-1} \sum_{k=2}^{K} (dt_k - dt_{median})} \qquad (5).$$

In weiterer vorteilhafter Ausgestaltung der vorliegenden Erfindung wird als die wenigstens eine Eigenschaft bestimmt, zu welchem Zeitpunkt $t_n$ in dem jeweiligen bestimmten Zyklus erstmalig ein erfasster Messwert des zyklischen Signals einen vorgegebenen Schwellenwert überschreitet oder in einem bestimmten Werteintervall liegt. Dieses bestimmte Werteintervall kann auch als Akquisitionsfenster bezeichnet werden. Das bestimmte Werteintervall kann vorgegeben sein oder automatisch festgelegt werden, beispielsweise anhand von während der Lernphase erfassten Messwerten des zyklischen Signals, beispielsweise in Bezug auf eine Amplitude des zyklischen Signals oder dergleichen. Als der Referenzwert beziehungsweise der Akquisitionsparameter wird auch hier die Referenzrepetitionszeit $TR_{prot}$ vorgegeben. Das Triggern wird dann in dem jeweiligen bestimmten Zyklus nur dann zugelassen, wenn zwischen der jeweils vorausgegangenen Einzelmessung und dem Zeitpunkt $t_n$ wenigstens die Referenzrepetitionszeit $TR_{prot}$ vergangen ist. In einem jeweiligen Zyklus kann also nur dann eine Einzelmessung ausgelöst werden, falls seit der jeweils vorherigen Einzelmessung mindestens die Referenzrepetitionszeit $TR_{prot}$ verstrichen ist bevor in dem jeweiligen Zyklus der erste Messwert erfasst wird, der den vorgegebenen Schwellenwert überschreitet oder in das Akquisitionsfenster fällt. Wurde in dem jeweiligen bestimmten Zyklus jedoch bereits ein Messwert erfasst, der den vorgegebenen Schwellenwert überschreitet oder in das Akquisitionsfenster fällt, bevor seit der jeweils letzten Einzelmessung, insbesondere seit deren Beginn oder Auslösen, die Referenzrepetitionszeit $TR_{prot}$ verstrichen ist, so wird in dem jeweiligen Zyklus keine Einzelmessung ausgelöst.

Dass der aktuelle Wert oder Messwert des zyklischen Signals in dem bestimmten Werteintervallen liegen muss, kann also als notwendige aber nicht alleinig hinreichende Trigger-Bedingung, also Bedingung zum Triggern, aufgefasst oder verwendet werden.

Ist also der zum Zeitpunkt $t_n$ erfasste Wert des zyklischen Signalpunktes der erste Messwert des zyklischen Signals, der während des jeweils aktuellen Zyklus in das Akquisitionsfenster fällt, dann wird das Triggern in dem jeweiligen bestimmten Zyklus nur dann zugelassen, wenn zwischen der jeweils vorausgegangenen Einzelmessung und dem Zeitpunkt $t_n$ wenigstens die Referenzrepetitionszeit $TR_{prot}$ vergangen ist. Mit anderen Worten wird also eine Einzelmessung während eines bestimmten Zyklus nur dann durchgeführt, wenn zu dem Zeitpunkt, zu dem der Signalwert eines während dieses Zyklus erfassten Messwerts zum ersten Mal in das Akquisitionsfenster fällt, mindestens die Referenzzeit $TR_{prot}$ seit der letzten Einzelmessung vergangen ist.

Bevorzugt umfasst ein Zyklus des zyklischen Signals jeweils eine absteigende und eine ansteigende Flanke des zyklischen Signals. Durchläuft das zyklische Signal dann, beispielsweise während der ansteigenden Flanke, das bestimmte Werteintervall in einem Zyklus bevor seit der letzten Einzelmessung die vorgegebene Repetitionszeit $TR_{prot}$ abgelaufen oder vergangen ist, so wird für diesen Zyklus das Triggern einer der Einzelmessungen nicht zugelassen.

Dadurch kann also verhindert werden, dass nach Ablauf der vorgegebenen Referenzrepetitionszeit $TR_{prot}$ eine Einzelmessung verzögert ausgelöst wird, wenn beispielsweise in der absteigenden Flanke das zyklische Signal erneut in das bestimmte Werteintervall eintritt. Effektiv wird also das Triggern einer der Einzelmessungen in einem bestimmten Zyklus genau dann nicht zugelassen, wenn das Einhalten der vorgegebenen Referenzrepetitionszeit $TR_{prot}$ in einem herkömmlichen getriggerten Messverfahren eine verzögerte Triggerung, also einen Fehltrigger, zur Folge hätte. Insgesamt wird so weiterhin sichergestellt, dass die Einzelmessungen konsistent zu einem optimalen Zeitpunkt oder einer optimalen Phase in einem Verlauf des zyklischen Signals ausgelöst werden, während gleichzeitig eine zum Akquirieren des Messdatensatzes insgesamt benötigte Zeit minimiert wird.

In weiterer vorteilhafter Ausgestaltung der vorliegenden Erfindung wird bestimmt, zu welchem Zeitpunkt $t_n$ in dem jeweiligen bestimmten Zyklus erstmalig ein erfasster Wert des zyklischen Signals einen vorgegebenen Schwellenwert überschreitet oder in einem bestimmten Werteintervall liegt. Hierzu sei auf die obigen Erläuterungen verwiesen. Als der Referenzwert beziehungsweise der Akquisitionsparameter wird hier jedoch ein maximaler SAR-Wert $SAR_{max}$ für wenigstens ein vorgegebenes Zeitintervall, welches den Zeitpunkt $t_n$ einschließt, vorgegeben. Dieser Wert $SAR_{max}$ kann bevorzugt für das jeweilige Zielobjekt, insbesondere den jeweiligen Patienten, individuell vorausberechnet oder angepasst sein, um eine Belastung des Patienten bedarfsgerecht zu begrenzen. Das Triggern wird in dem jeweiligen bestimmten Zyklus nur dann zugelassen, falls durch eine zum Zeitpunkt $t_n$ getriggerte der Einzelmessungen der vorgegebene maximale SAR-Wert $SAR_{max}$ nicht überschritten würde.

Der vorgegebene maximale SAR-Wert kann dabei mehrere SAR-Einzelwerte umfassen, welche für mehrere unterschiedlich lange vorgegebene Zeitintervalle, also unterschiedliche Klassen von Zeitintervallen, vorgegeben sein können. So kann beispielsweise ein erster SAR-Einzelwert für Zeitintervalle von 2 s Dauer, ein zweiter SAR-Einzelwert für Zeitintervalle von 10 s Dauer und ein dritter SAR-Einzelwert für Zeitintervalle von 60 s Dauer vorgegeben sein. Die SAR-Einzelwerte können dabei unterschiedlich groß sein in Abhängigkeit von einer Länge oder Dauer des Zeitintervalls, für welches sie vorgegeben sind. Zeitintervalle einer bestimmten Klasse, also Dauer, können sich dabei jeweils kontinuierlich wiederholen. Das bedeutet, dass eine Gesamtzeit einer Untersuchung oder Messung des Zielobjekts vollständig in Zeitintervalle jeder Klasse unterteilt werden kann und in keinem dieser Zeitintervalle der jeweilige SAR-Einzelwert beziehungsweise der maximale SAR-Wert$_{max}$ überschritten werden darf. Ein bestimmter Zeitpunkt kann also gleichzeitig in mehreren Zeitintervallen unterschiedlicher Klassen oder Dauern enthalten sein.

Das Triggern wird in dem jeweiligen bestimmten Zyklus also nur dann zugelassen, wenn zu dem Zeitpunkt, zu dem der Signalwert eines während dieses Zyklus erfassten Messwerts zum ersten Mal in das Akquisitionsfenster fällt, die jeweils nächste der Einzelmessungen keinen der SAR-Werte in den jeweiligen Zeitintervallen überschreiten wird.

Ein jeweils aktueller, also während der bisherigen Einzelmessungen, also über das bisherige Akquirieren von Daten für den Messdatensatzes, oder die bisherige Untersuchung des Zielobjekts hinweg erreichter oder bereits applizierter SAR-Wert kann dabei laufend mitprotokolliert oder simuliert werden. Wurde das Zielobjekt oder beispielsweise ein anderer Teil des jeweiligen Patienten bereits vor Beginn des Akquirierens des aktuellen Messdatensatzes mittels der Magnetresonanzanlage abgebildet, so können auch dabei kumulierte SAR-Werte, also Energieeinträge, berücksichtigt werden.

Ebenso kann dann ein Beitrag jeder beziehungsweise der jeweils nächsten Einzelmessung simuliert oder abgeschätzt werden, um - insbesondere automatisch - zu bestimmen, ob $SAR_{max}$ oder einer der entsprechenden Einzelwerte in einem der genannten Zeitintervalle durch die jeweilige Einzelmessung überschritten würde, wenn diese zum jeweils aktuellen Zeitpunkt $t_n$ ausgelöst würde. Dies kann also jeweils bis zum Zeitpunkt $t_n$ durchgeführt werden. Ebenso ist es aber möglich, eine entsprechende Berechnung zum Zeitpunkt $t_n$ zu beginnen, um eine Entscheidung darüber zu treffen, ob in dem aktuellen Zyklus eine der Einzelmessungen ausgelöst wird. Dabei können jeweils zum Zeitpunkt $t_n$ und/oder während der geplanten nächsten Einzelmessung laufende Zeitintervalle berücksichtigt werden.

Mit anderen Worten wird also eine Einzelmessung während eines bestimmten Zyklus nur dann durchgeführt, wenn zu dem Zeitpunkt, zu dem der Signalwert eines während dieses Zyklus erfassten Messwerts zum ersten Mal in das Akquisitionsfenster fällt und durch die jeweils nächste Einzelmessung keiner der SAR_Werte während der jeweiligen Zeitintervalle überschreiten wird.

Mit anderen Worten wird also ein Zyklus ausgelassen, in diesem Zyklus also keine der Einzelmessungen ausgelöst, wenn durch diese Einzelmessung $SAR_{max}$ oder einer der Einzelwerte überschritten würde. Insbesondere wird der jeweilige Zyklus dann vollständig ausgelassen, die nächste Einzelmessung also erst dann wieder zugelassen, nachdem ein Beginn eines neuen Zyklus des zyklischen Signals eindeutig erkannt worden ist.

Es kann beispielsweise der Fall auftreten, dass in der beschriebenen Weise das zyklische Signal zu Beginn des nächsten Zyklus oder während der entsprechenden ansteigenden und absteigenden Flanke in das bestimmte Werteintervall fällt. Weiter könnte beispielsweise während der ansteigenden Flanke durch die jeweilige nächste Einzelmessung aber einer der SAR-Werte in zumindest einem der dann laufenden Zeitintervalle überschritten werden, während der späteren absteigenden Flanke aber nicht. In einem herkömmlichen Verfahren würde dann die Einzelmessung verzögert während der absteigenden Flanke getriggert. Das zyklische Signal befindet sich dann jedoch nicht in einer optimalen Phase, sodass das herkömmliche getriggerte Messverfahren in diesem Fall zu einem Fehltrigger und somit

EP 3 599 477 B1

letztlich zu einer verschlechterten Bildqualität führen würde, während durch das vorliegende Verfahren eben dies verhindert wird. Auch in dieser Ausführungsform der vorliegenden Erfindung kann also vorteilhaft eine optimale Daten- oder Bildqualität bei hierfür minimaler Gesamtmesszeit zum Akquirieren des Messdatensatzes erreicht werden.

In weiterer vorteilhafter Ausgestaltung der vorliegenden Erfindung sind die Einzelmessungen jeweils kürzer als ein Zyklus, also als eine Zykluslänge oder Periodendauer, des zyklischen Signals. Mit anderen Worten werden also nur während bestimmter Teile oder während einer bestimmten Phase des zyklischen Signals Messdaten für den Messdatensatzes akquiriert, beispielsweise gemäß oder mittels einer nur dann aktiven MR-Messsequenz. Hierdurch kann vorteilhaft die bereits genannte verbesserte Bildqualität besonders zuverlässig und konsistent erreicht werden. Ebenso wird es vorteilhaft ermöglicht, dieselbe Magnetresonanzanlage sowohl zum Erfassen des zyklischen Signals als auch zum Akquirieren der Messdaten für den Messdatensatzes zu verwenden, insbesondere auch dann, wenn die Magnetresonanzanlage dies nicht gleichzeitig bewerkstelligen kann. Das zyklische Signal kann dann also nur in den Zeiten oder Phasen des zyklischen Signals erfasst werden, in denen keine Messdaten für den Messdatensatzes akquiriert werden. Dies kann jedoch zum Erkennen und Charakterisieren des zyklischen Signals, also beispielsweise zum Bestimmen einer aktuellen Phase des zyklischen Signals, ausreichend sein. Es kann beispielsweise vorgesehen sein, dass die Messdaten für den Messdatensatz nur während der Ausatem-Phase für eine vorgegebene Zeitdauer akquiriert werden. Die vorgegebene Dauer oder Zeit für jede der Einzelmessungen kann dabei in Abhängigkeit von der bestimmten mittleren Dauer eines Zyklus des zyklischen Signals, also der mittleren Zyklusdauer, derart vorgegeben sein, dass die Einzelmessung in einem Zyklus typischer, also mittlerer, Länge mit oder bereits vor Ende der Ausatem-Phase abgeschlossen ist. Auf diese Weise kann vorteilhaft die Erkenntnis ausgenutzt werden, dass während dieser Phase des Atemzyklus akquirierte Messdaten zu einer besonders guten Bildqualität führen können.

In weiterer vorteilhafter Ausgestaltung der vorliegenden Erfindung wird als das zyklische Signal ein Herzschlag erfasst.

In weiterer vorteilhafter Ausgestaltung der vorliegenden Erfindung wird als das zyklische Signal eine Atemkurve erfasst. Die Atemkurve beschreibt dabei eine durch ein Atmen, also das Ein- und Ausatmen, bedingte Bewegung des Zielobjekts, hier also eines Patienten oder eines Teils des Patienten. Zum Erfassen der Atemkurve kann beispielsweise eine Bewegung, also ein zyklisches oder rhythmisches Ausdehnen, eines Brustkorbs des Patienten oder beispielsweise eine entsprechende Bewegung eines Zwerchfells des Patienten erfasst werden. Das Erfassen der Atemkurve als das zyklische Signal ist hier besonders vorteilhaft, da mit dem Atmen signifikante Bewegungen des Patienten einhergehen und das Berücksichtigen der Atemkurve und deren wenigstens einer bestimmter Eigenschaft bei dem Akquirieren des Messdatensatzes dementsprechend zu einer signifikanten Verbesserung der Bildqualität führen oder beitragen kann.

In vorteilhafter Weiterbildung der vorliegenden Erfindung werden automatisch unterschiedliche Phasen oder Atemphasen der Atemkurve, insbesondere die Phase "Einatmen" und die Phase "Ausatmen", erkannt und das Triggern einer der Einzelmessungen nur während der Phase "Ausatmen" zugelassen. Dazu kann jedem erfassten Wert oder Messwert des zyklischen Signals die jeweils aktuelle Atemphase zugeordnet werden. Eine notwendige Bedingung für das Triggern einer der Einzelmessungen kann also sein, dass einem jeweils zuletzt erfassten Wert die Atemphase "Ausatmen" zugeordnet worden ist. Während der initialen Lernphase, während derer das zyklische Signal erstmalig erfasst und noch keine Messdaten für den Messdatensatzes akquiriert werden, kann dabei einem Messwert oder Signalpunkt des zyklischen Signals ebenso die Atemphase "unbekannt" zugeordnet werden, beispielsweise wenn noch nicht genügend Messwerte zur Verfügung stehen, um die jeweils aktuelle Phase eindeutig zu bestimmen. Ist jedoch einmal einem Messwert des zyklischen Signals die Phase "Einatmen" oder "Ausatmen" zugeordnet, so wird im Folgenden dann nur noch zwischen diesen beiden Phasen gewechselt und nicht erneut die Phase "unbekannt" zugewiesen.

Bevorzugt kann zudem ein absoluter oder relativer Schwellenwert, beispielsweise ein Mindestabstand zu einem Minimalwert des zyklischen Signals, vorgegeben sein, welchen das zyklische Signal während der Phase "Ausatmen" oben als notwendige Bedingung zum Triggern einer der Einzelmessungen erreicht oder überschritten haben muss. Dadurch kann erreicht werden, dass die Einzelmessungen nicht unmittelbar nach Beginn der Phase "Ausatmen" ausgelöst werden, wodurch die Messdaten für den Messdatensatzes besonders zuverlässig und konsistent akquiriert werden können und dementsprechend eine besonders gute Bildqualität erreicht werden kann. Ebenso kann ein weiterer Schwellenwert vorgegeben sein, in dem sich das zyklische Signal aktuell als notwendige Bedingung befinden muss, um eine der Einzelmessungen zu triggern. Dies kann also dem vorliegend bereits an anderer Stelle genannten bestimmten Werteintervall entsprechen.

Um die unterschiedlichen Phasen der Atemkurve automatisch zu erkennen oder zu bestimmen, kann ein entsprechender Datenverarbeitungsalgorithmus eingesetzt werden, beispielsweise basierend auf einem Berechnen einer Steigung des zyklischen Signals, einem Vergleich eines jeweils aktuellen Messwertes mit vorausgegangenen Messwerten oder einer Bilderkennung.

Ein weiterer Aspekt der vorliegenden Erfindung ist ein Computerprogramm oder Computerprogrammprodukt, welches die Verfahrensschritte zumindest einer Ausführungsform des erfindungsgemäßen Verfahrens kodiert oder repräsentiert und zum Laden in einen Datenspeicher einer Magnetresonanzanlage zum Ausführen der Verfahrensschritte eingerichtet ist. Das erfindungsgemäße Computerprogramm kann Programm-Mittel umfassen, um das erfindungsgemäße Verfahren auszuführen, wenn das erfindungsgemäße Computerprogramm durch die Magnetresonanzanlage, insbesondere eine entsprechende Datenverarbeitungseinrichtung der Magnetresonanzanlage, ausgeführt wird.

Ein weiterer Aspekt der vorliegenden Erfindung ist ein, insbesondere elektronischer und/oder elektronisch lesbarer, Datenspeicher oder Datenträger, in dem ein Programmcode gespeichert ist, welcher zumindest eine Ausführungsform des erfindungsgemäßen Computerprogramms umfasst. Der erfindungsgemäße Datenspeicher kann also insbesondere der im Zusammenhang mit dem erfindungsgemäßen Computerprogramm genannte Datenspeicher sein. Der in dem erfindungsgemäßen Datenspeicher gespeicherten Programmcode ist insbesondere dazu ausgebildet und eingerichtet, automatisch mittels einer Prozessoreinrichtung - welche Teil der Magnetresonanzanlage ist - automatisch ausgeführt zu werden, um das erfindungsgemäße Verfahren durchzuführen, also die Durchführung oder Ausführung des erfindungsgemäßen Verfahrens zu bewirken. Die Prozessoreinrichtung kann insbesondere ein Mikroprozessor oder Mikrocontroller sein oder einen solchen umfassen. In dem erfindungsgemäßen Datenspeicher können, insbesondere als Teil des gespeicherten Programmcodes, zudem weitere Steueranweisungen für die genannte Datenverarbeitungseinrichtung, Prozessoreinrichtung und/oder Magnetresonanzanlage gespeichert oder kodiert sein.

Ein weiterer Aspekt der vorliegenden Erfindung ist eine Magnetresonanzanlage zum getriggerten Akquirieren eines Messdatensatzes eines Zielobjekts, insbesondere eines Patienten oder eines Teils eines Patienten, in mehreren Einzelmessungen. Dazu umfasst die erfindungsgemäße Magnetresonanzanlage eine Erfassungseinrichtung zum Erfassen eines zyklischen Signals, welches eine zyklische Veränderung des Zielobjekts beschreibt. Weiter umfasst die erfindungsgemäße Magnetresonanzanlage eine Messeinrichtung zum Akquirieren des Messdatensatzes, und eine Datenverarbeitungseinrichtung. Diese Datenverarbeitungseinrichtung umfasst ihrerseits einen erfindungsgemäßen Datenspeicher und eine mit diesem verbundene Prozessoreinrichtung zum Ausführen des in dem Datenspeicher gespeicherten Programmcodes. Mit anderen Worten ist die Magnetresonanzanlage also zum Durchführen des erfindungsgemäßen Verfahrens eingerichtet. Dementsprechend kann die erfindungsgemäße Magnetresonanzanlage insbesondere die im Zusammenhang mit den übrigen Aspekten der vorliegenden Erfindung, also im Zusammenhang mit dem erfindungsgemäßen Verfahren, dem erfindungsgemäßen Computerprogramm und/oder dem erfindungsgemäßen Datenspeicher, genannte Magnetresonanzanlage sein. Die erfindungsgemäße Magnetresonanzanlage kann dementsprechend also einige oder alle der im Zusammenhang mit den übrigen Aspekten der vorliegenden Erfindung genannten Eigenschaften und/oder Bauteile oder Komponenten aufweisen.

In gleicher Weise können Maßnahmen oder Vorgänge, welche im Zusammenhang mit dem erfindungsgemäßen Computerprogramm, dem erfindungsgemäßen Datenspeicher und/oder der erfindungsgemäßen Magnetresonanzanlage genannt oder beschrieben sind, Teil des erfindungsgemäßen Verfahrens sein oder dieses ergänzen oder weiterbilden.

Die bisher und im Folgenden angegebenen Eigenschaften und Weiterbildungen des erfindungsgemäßen Verfahrens, des erfindungsgemäßen Computerprogramms, des erfindungsgemäßen Datenspeichers und der erfindungsgemäßen Magnetresonanzanlage sowie die entsprechenden Vorteile sind jeweils sinngemäß wechselseitig zwischen diesen Aspekten der Erfindung übertragbar. Es gehören also zu der Erfindung auch solche Weiterbildungen des erfindungsgemäßen Verfahrens, des erfindungsgemäßen Computerprogramms, des erfindungsgemäßen Datenspeichers und der erfindungsgemäßen Magnetresonanzanlage, welche Ausgestaltungen aufweisen, die hier zur Vermeidung unnötiger Redundanz nicht explizit in der jeweiligen Kombination oder für jeden dieser Aspekte der Erfindung separat beschrieben sind.

Weitere Merkmale, Einzelheiten und Vorteile der vorliegenden Erfindung ergeben sich aus der nachfolgenden Beschreibung bevorzugter Ausführungsbeispiele sowie anhand der Zeichnungen. Dabei zeigen:

FIG 1    eine diagrammatische Darstellung zur Veranschaulichung einer verzögerten Triggerung bei einer anhand einer Atmung getriggerten herkömmlichen Messung;

FIG 2    einen beispielhaften schematischen Ablaufplan eines Verfahrens zum getriggerten Akquirieren eines Messdatensatzes;

FIG 3    eine beispielhafte schematische Programmschema zur Veranschaulichung eines Algorithmus zum Zuordnen einer jeweiligen Atemphase zu Messwerten einer Atemkurve;

FIG 4    eine Darstellung zur Veranschaulichung einer herkömmlichen getriggerten MR-Datenakquirierung und einer resultierenden eingeschränkten Bildqualität; und

FIG 5    eine Darstellung zur Veranschaulichung einer verbesserten getriggerten MR-Datenakquirierung und einer resultierenden verbesserten Bildqualität.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Bei Messungen, also bei einem Abbilden eines Patienten, mittels einer Magnetresonanzanlage können als Teil einer entsprechenden MR-Sequenz ausgespielte Hochfrequenz- oder RF-Pulse zu einer unerwünschten Erwärmung des Patienten durch eine dabei in den Patienten eingebrachte elektromagnetische Energie führen. Diese Erwärmung wird gemessen oder quantifiziert mithilfe der spezifischen Absorptionsrate (SAR, englisch: "Specific Absorption Rate"), welche die elektromagnetische Energie (RF-Energie) angibt, welche in einem bestimmten Zeitintervall pro Kilogramm Körpergewicht absorbiert wird. Ein maximal zulässiger Wert für die SAR ist gesetzlich limitiert und kann mittels der Magnetresonanzanlage zur Laufzeit überprüft oder abgeschätzt werden. Wird ein entsprechend vorgegebener Grenzwert zur Laufzeit, also bei einer Messung oder Untersuchung, erreicht oder überschritten, so wird die entsprechende Messung abgebrochen. Nach einem solchen Abbruch ist in der Regel keine oder nur eine unvollständige Bildberechnung möglich.

Um solche Messabbrüche daher zu vermeiden, wird vor der Messung ein bei der Messung, also durch die jeweils verwendete MR-Sequenz oder Pulssequenz, voraussichtlich erreichter SAR-Wert vor der Messung simuliert oder zumindest näherungsweise berechnet. Sofern sich dabei ergibt, dass der Grenzwert voraussichtlich überschritten wird beziehungsweise würde, können dann verschiedene Parameter der MR-Sequenz oder eines Protokolls für die Messung angepasst werden. Zum Reduzieren des SAR-Wertes kann beispielsweise ein Anregungs- oder Flipwinkel eines RF-Pulses der MR-Sequenz reduziert oder eine Repetitionszeit TR, also die Zeit, die zwischen zwei aufeinanderfolgenden RF-Pulsen zur Anregung einer bestimmten Schicht des Patienten vergeht, verlängert werden.

Eine getriggerten Messung ist in der Magnetresonanz-Bildgebung oder Magnetresonanz-Spektroskopie eine Methode, bei der jeweils ein Teil der MR-Sequenz, also beispielsweise jeweils ein RF-Puls zur Anregung, durch einen Trigger ausgelöst wird, also beispielsweise wenn eine bestimmte vorgegebene Bedingung erfüllt und/oder ein bestimmtes vorgegebenes Ereignis eingetreten ist. Ein solcher Trigger kann beispielsweise anhand einer Atmung vorgegeben und überwacht werden, was dann Atemtriggerung bezeichnet werden kann. Gegenüber einer kontinuierlichen, nicht getriggerten Messung können durch die Atemtriggerung Bewegungsartefakte, welche infolge einer Atembewegung beim Atmen entstehen können, reduziert werden, indem die Messung mit der Atmung des Patienten synchronisiert wird. Dazu wird die Atmung des Patienten erfasst.

Ein Aufnehmen oder Akquirierung von MR-Messdaten, aus denen dann letztlich beispielsweise ein Bild rekonstruiert wird, erfolgt dabei bevorzugt in sogenannten Akquisitionsphasen (englisch auch "Imaging Phase"). Diese Akquisitionsphasen sind bevorzugt jeweils kürzer als ein Atemzyklus und werden vorliegend jeweils in einer bestimmten Atemphase des Patienten, also zu einem bestimmten Zeitpunkt oder in einer bestimmten Phase oder Zeitspanne des Atemzyklus, gestartet, welche beziehungsweise welcher für alle Akquisitionsphasen gleich ist.

Beispielsweise wird eine bestimmte Schicht des Patienten einmal pro Atemzyklus angeregt, wobei ein Atemzyklus ein vollständiges Einatmen und ein vollständiges Ausatmen umfasst. Die resultierende tatsächliche Repetitionszeit der Messung beziehungsweise der verwendeten MR-Sequenz wird dann durch die Atmung oder eine Atemfrequenz des Patienten bestimmt. Die in einer nicht getriggerten Sequenz oder Messung konstante vorgegebene Repetitionszeit wird bei einer getriggerten Messung, beispielsweise für Berechnungszwecke oder zur Veranschaulichung durch eine sogenannte effektive Repetitionszeit $TR_{eff}$ ersetzt, welche im vorliegenden Beispiel gleich einer mittleren Länge eines Atemzyklus des Patienten ist. Bei einer derartigen atemgetriggerten Messung oder Sequenz hängt der resultierende tatsächliche SAR-Wert also von der Atmung des Patienten ab. Diese ist patientenindividuell und kann insbesondere unregelmäßig sein, sodass eine genaue Vorhersage des tatsächlich bei der Messung entstehenden SAR-Wertes unmöglich ist.

Um Messabbrüche während einer atemgetriggerten MR-Messung zu vermeiden, können eine Vorausberechnung des voraussichtlich während der MR-Messung erreichten SAR-Wertes und gegebenenfalls eine entsprechende Anpassung von Parametern der MR-Sequenz oder eines entsprechenden Protokolls auf Basis eines sogenannten Protokoll-TR-Wertes, also einer vorgegebenen Referenzzeit oder Protokoll- oder Referenzrepetitionszeit $TR_{prot}$, erfolgen. Diese Protokoll- oder Referenzrepetitionszeit $TR_{prot}$ kann als Teil der Sequenz oder des Protokolls oder durch einen Anwender vorgegeben sein und sich beispielsweise an Erfahrungswerten orientieren. $TR_{prot}$ kann beispielsweise zu 2,4 s vorgegeben sein. Eine tatsächliche Länge eines Atemzyklus eines individuellen Patienten kann demgegenüber jedoch bedeutend länger sein, beispielsweise 3 bis 6 Sekunden betragen. Zur Laufzeit, also bei der MR-Messung, bestimmt die Referenzrepetitionszeit $TR_{prot}$ eine minimale Zeit zwischen zwei aufeinanderfolgenden Triggern. Ein Trigger wird also nur dann generiert, das heißt eine Einzelmessung oder ein RF-Puls zur Anregung wird nur dann ausgelöst, falls eine seit dem letzten Trigger oder Trigger-Ereignis vergangene Zeit wenigstens so lang wie die vorgegebene Referenzrepetitionszeit $TR_{prot}$ ist. Der tatsächliche SAR-Wert, der sich bei der MR-Messung dann ergibt, ist dadurch immer kleiner oder gleich dem auf Basis der vorgegebenen Referenzrepetitionszeit $TR_{prot}$ vorausberechneten SAR-Wert, der gegebenenfalls durch eine entsprechende Anpassung von Parametern der MR-Sequenz bereits die gesetzlichen Vorgaben für den maximalen SAR-Wert $SAR_{max}$ einhält.

Wird die vorgegebene Referenzrepetitionszeit $TR_{prot}$ kürzer als eine minimale Länge eines Atemzyklus des Patienten gewählt, beeinflusst dieser Mechanismus die Atemtriggerung in der Regel nicht. Wird eine gewünschte Atemphase, welche als Trigger vorgegeben ist, erkannt, so ist dann aufgrund der kurz gegenüber der Länge des Atemzyklus gewählten Referenzrepetitionszeit $TR_{prot}$ die seit dem letzten Trigger vergangene Zeit dann schon länger als die vorgegebene Referenzrepetitionszeit $TR_{prot}$ und die entsprechende Einzelmessung beziehungsweise der entsprechende RF-Puls zur Anregung kann ausgelöst beziehungsweise generiert werden.

Problematisch kann dabei aber sein, dass der auf Basis der vorgegebenen Referenzrepetitionszeit $TR_{prot}$ vorausgesagte oder vorausberechnete SAR-Wert wesentlich höher sein kann als der sich bei der MR-Messung ergebende tatsächliche SAR-Wert. Die vorgegebene Referenzrepetitionszeit $TR_{prot}$ wird also kurz gewählt, um die Atemtriggerung nicht zu beeinflussen oder zu stören, der tatsächliche SAR-Wert ist jedoch aufgrund der im Vorhinein unbekannten Atemfrequenz des Patienten unbekannt. Aus Sicherheitsgründen, insbesondere um die gesetzlichen Vorgaben für den maximalen SAR-Wert $SAR_{max}$ einzuhalten, werden daher die Parameter der MR-Messung oder Sequenz anhand des auf Basis der vorgegebenen Referenzrepetitionszeit $TR_{prot}$ vorausberechneten SAR-Wertes angepasst oder eingestellt. Dies kann sich jedoch nachteilig auf eine resultierende Daten- oder Bildqualität und/oder eine Effizienz der MR-Messung auswirken. Letzteres ist beispielsweise dann der Fall, wenn eine Anzahl von Schichten, aus welchen MR-Messdaten in einem Atemzyklus akquiriert werden, reduziert wird, um den maximalen SAR-Wert $SAR_{max}$ einzuhalten. Da wie erläutert der vorausberechnete SAR-Wert jedoch deutlich höher sein kann als der tatsächliche SAR-Wert, könnte insbesondere bei einem relativ langen Atemintervall oder Atemzyklus eine derartige Anpassung der Parameter für die MR-Messung oder Sequenz hinsichtlich des Einhaltens des vorgegebenen maximalen SAR-Wertes $SAR_{max}$ letztlich unnötig sein oder eine geringere Reduktion hätte ausreichen können.

Wird hingegen die vorgegebene Referenzrepetitionszeit $TR_{prot}$ so gewählt, dass sie zumindest im Wesentlichen so lang ist wie ein mittlerer Atemzyklus des jeweiligen Patienten, so ist der auf Basis der vorgegebenen Referenzrepetitionszeit $TR_{prot}$ vorausberechneten SAR-Wert in der Regel nur wenig kleiner als der tatsächliche SAR-Wert, stimmt also mit diesem besser überein. Hierdurch wird eine unnötige Limitierung der Parameter der MR-Messung oder Sequenz vermieden. Bei herkömmlichen atemgetriggerten Messungen kann es dann aber zu einer negativen, also unerwünschten Beeinflussung der Atemtriggerung kommen.

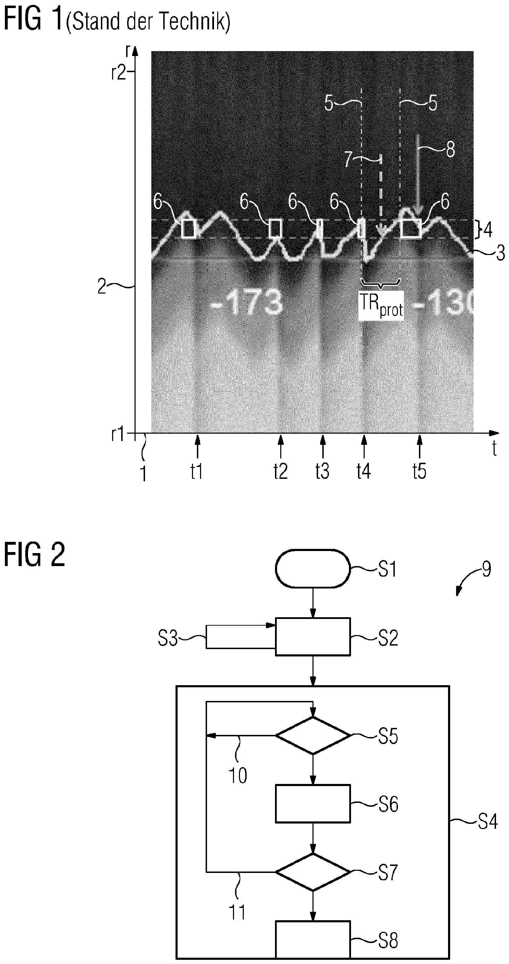

Eine solche unerwünschte Beeinflussung der Atemtriggerung ist in FIG 1 veranschaulicht. Dazu ist auf einer x-Achse 1 die Zeit t und auf einer y-Achse 2 ein Ort oder eine Ortskoordinate r aufgetragen. Für die vorliegende Darstellung wurde eine Position oder relative Position eines Zwerchfells (Diaphragma) eines Patienten mittels einer MR-Navigatorsequenz erfasst. Auf der y-Achse 2 ist dabei der Ort r entlang einer Körperlängsachse des Patienten im Bereich des Zwerchfells aufgetragen. Bei r1 sind Messwerte aus der Leber und bei r2 Messwerte aus der Lunge aufgetragen. Eine Position des Zwerchfells zwischen der Leber und der Lunge korrespondiert mit einem Atemzyklus des Patienten und verändert sich dementsprechend zyklisch mit der Zeit während der Patient atmet. Überlagert dargestellt ist hier eine entsprechende Atemkurve 3, welche die aus mit der Navigatorsequenz gemessenen MR-Daten bestimmte relative Position, also die zyklische Bewegung des Zwerchfells, beschreibt oder widerspiegelt. Die Atemkurve 3 und die zugrunde liegenden, mittels der MR-Navigatorsequenz gemessenen Daten sind hier nicht kontinuierlich erfasst und dargestellt, sondern mit zeitlichen Sprüngen oder Unterbrechungen zu den Zeitpunkten t1, t2, t3, t4 und t5. Hier wurde jeweils eine Einzelmessung zum Aufnehmen von MR-Messdaten aus einem anderen Bereich des Patienten für einen Messdatensatz getriggert und daher die MR-Navigatorsequenz zum Erfassen der Atemkurve 3 unterbrochen.

Weiter ist vorliegend ein Akquisitionsfenster 4 vorgegeben und durch zwei gestrichelte, parallel zur x-Achse 1 verlaufende Hilfslinien veranschaulicht. Das Akquisitionsfenster 4 definiert einen Wertebereich oder ein Werteintervall, in welchem die Atemkurve 3 als notwendige Trigger-Bedienung jeweils aktuell verlaufen muss. Es ist also eine notwendige aber nicht alleinig hinreichende Bedingung für einen Trigger, dass eine jeweils zuletzt gemessene relative Position des Zwerchfells in das Akquisitionsfenster 4 fällt. Eine weitere hier relevante, vorgegebene, notwendige Trigger-Bedingung ist, dass seit dem jeweils letzten Trigger oder Trigger-Ereignis eine Zeit verstrichen ist, welche länger oder gleich der vorgegebenen Referenzrepetitionszeit $TR_{prot}$ ist. Ein Zeitintervall der Länge $TR_{prot}$ ist hier beispielhaft durch zwei Hilfslinien 5 veranschaulicht. Ebenso können weitere Trigger-Bedingungen vorgegeben sein.

Weiter sind hier mehrere Akzeptanzfenster 6 gekennzeichnet. Die Akzeptanzfenster 6 kennzeichnen Bereiche, für welche eine entsprechende Überprüfung für alle notwendigen Trigger-Bedingungen mit Ausnahme der Bedingung, dass die zuletzt gemessene Zwerchfellposition innerhalb des Akquisitionsfensters 4 liegt, ergeben hat, dass die jeweilige Trigger-Bedingung erfüllt ist. Das bedeutet nicht notwendigerweise, dass in den Bereichen der Akzeptanzfenster 6 die ausgenommene Bedingung nicht erfüllt ist, sondern lediglich, dass diese Bedingung zum Anzeigen der Akzeptanzfenster 6 nicht überprüft wird oder worden ist. Eine der notwendigen Trigger-Bedingungen ist hier, dass der Patient ausatmet, sich die Atemkurve 3 also in der Ausatem-Phase befindet.

Eine Einzelmessung zum Akquirieren von MR-Messdaten für den Datensatz wird also getriggert, wenn die Atemkurve 3 in eines der Akzeptanzfenster 6 eintritt und dies automatisch erkannt worden ist. Ein, insbesondere vorgegebener, optimaler Triggerzeitpunkt, also ein Zykluspunkt innerhalb der zyklischen Atemkurve 3, an welchem idealerweise in einem bestimmten Atemzyklus ein jeweiliger Trigger erfolgt, ist hier durch einen ersten Pfeil 7 beispielhaft für einen Atemzyklus gekennzeichnet.

In der vorliegenden Darstellung entspricht ein Ansteigen der Atemkurve 3 einem Ausatmen und ein Abfallen der Atemkurve 3 einem Einatmen. Idealerweise würde ein Trigger also jeweils ausgelöst werden, wenn die Atemkurve von kleineren Werten aus ansteigend, also während eines Ausatmens, in das Akquisitionsfenster 4 eintritt. Zu dem mittels des ersten Pfeils 7 beispielhaft gekennzeichneten optimalen Triggerzeitpunkt kann vorliegend jedoch kein Trigger erfolgen, da seit dem letzten Trigger zum Zeitpunkt t4 noch nicht die vorgegebene Referenzrepetitionszeit $TR_{prot}$ verstrichen ist.

Zu dem gekennzeichneten optimalen Triggerzeitpunkt wurde bereits erkannt, dass sich die Atemkurve 3 in einer Ausatmen-Phase befindet, sodass unmittelbar nach Ablauf der vorgegebenen Referenzrepetitionszeit $TR_{prot}$ das nächste Akzeptanzfenster 6 angezeigt wird. Nach Ablauf der gekennzeichneten vorgegebenen Referenzrepetitionszeit $TR_{prot}$ liegt vorliegend die Atemkurve 3 jedoch bereits oberhalb des Akquisitionsfensters 4, sodass zunächst keine Triggerung erfolgt. Stattdessen erfolgt vorliegend eine verzögerte Triggerung zu einem durch einen zweiten Pfeil 8 gekennzeichnet Zeitpunkt, zu dem die zuletzt gemessene Position des Zwerchfells, also die Atemkurve 3, in das entsprechende Akzeptanzfenster 6 fällt.

Für einen Betrachter ist anschaulich zwar erkennbar, dass zu diesem Zeitpunkt die Atemkurve oder der Atemzyklus sich bereits in einer anschließenden Einatmen-Phase befinden. Damit sollte zu diesem Zeitpunkt eigentlich keine Triggerung erfolgen, da als eine notwendige Bedienung vorgegeben ist, dass eine Triggerung nur während einer Ausatmen-Phase erfolgen soll. Es ist jedoch ein Schwellenwert zum Erkennen eines Wechsels des Atemzyklus oder der Atemphase vorgegeben, durch welchen berücksichtigt wird, dass das der Atemkurve 3 zugrunde liegende Signal rauschbehaftet ist und somit nicht nur infolge des Atmens, sondern ebenso infolge des Rauschens variieren kann. Dies führt dazu, dass zu dem durch den zweiten Pfeil 8 gekennzeichneten Zeitpunkt noch nicht automatisch erkannt worden ist, dass sich die Atemkurve bereits in der anschließenden Einatmen-Phase befindet. Daher erfolgt vorliegend zu dem durch den zweiten Pfeil 8 gekennzeichneten Zeitpunkt ein verzögerter Trigger oder Fehltrigger, welcher dazu führt, dass zum Zeitpunkt t5 eine Einzelmessung zum Akquirieren von MR-Messdaten für den Messdatensatzes ausgelöst wird. Die entsprechenden MR-Messdaten werden hier also nicht zu dem optimalen Zeitpunkt oder während der optimalen Phase während des Atemzyklus beziehungsweise der Atemkurve 3 erfasst. Dadurch ergibt sich letztlich eine unregelmäßige effektive Repetitionszeit $TR_{eff}$ und eine verschlechterte Bildqualität. Zu dem durch den ersten Pfeil 7 gekennzeichneten optimalen Zeitpunkt oder Zykluspunkt innerhalb des Atemzyklus kann jedoch kein Trigger generiert oder ausgelöst werden, da eine Akquirierung von MR-Messdaten zu diesem Zeitpunkt dazu führen könnte, dass der vorgegebene maximale SAR-Wert $SAR_{max}$ überschritten würde, was wiederum zum sofortigen Abbruch der Messung führen würde.

Eine individuelle Anpassung der vorgegebenen Referenzrepetitionszeit $TR_{prot}$ an den individuellen Atemzyklus oder die individuelle Atemfrequenz des jeweiligen Patienten überfordert erfahrungsgemäß viele Anwender oder Nutzer. Dementsprechend ist die vorgegebene Referenzrepetitionszeit $TR_{prot}$ üblicherweise signifikant kürzer als ein Atemzyklus der meisten Patienten. Dies führt wie beschrieben nachteilig zu einer unnötigen Limitierung von Parametern der MR-Messung oder Sequenz für die meisten Patienten und eine suboptimale beziehungsweise variierende Triggerung, also eine verzögerte oder Fehltriggerung, für wenige Patienten mit einem ungewöhnlich kurzen Atemintervall in der Größenordnung, also von ähnlicher Länge, wie die vorgegebene Referenzrepetitionszeit $TR_{prot}$.

Um diesen Problemen zu begegnen besteht also Bedarf für ein verbessertes Verfahren. FIG 2 zeigt einen beispielhaften schematischen Ablaufplan 9 für ein solches verbessertes Verfahren zum getriggerten Akquirieren eines Messdatensatzes in mehreren Einzelmessungen, welches robust ist gegenüber Situationen, in denen die vorgegebene Referenzrepetitionszeit $TR_{prot}$ zumindest im Wesentlichen oder ungefähr so lang ist wie der mittlere Atemzyklus des jeweiligen Patienten. Das Verfahren beginnt in einem Verfahrensschritt S1. Hier können beispielsweise der Patient in der jeweiligen Magnetresonanzanlage positioniert, die Magnetresonanzanlage aktiviert und eine Sequenz oder ein Protokoll für die MR-Messung und entsprechende Parameter vorgegeben oder angepasst werden.

In einem Verfahrensschritt S2 wird ein Erfassen der Atemkurve 3 des Patienten gestartet. Dabei wird während einer sogenannten Lernphase die Atmung beziehungsweise die Atemkurve 3 nur erfasst und analysiert, um geeignete Merkmale oder Eigenschaften zu finden, zu bestimmen oder festzulegen, die zum Definieren von Triggern oder Trigger-Ereignissen verwendet werden, also in einer späteren Mess- oder Abbildungsphase einen Trigger generieren, also eine entsprechende Einzelmessung auslösen können. Während dieser Lernphase werden demnach also noch keine Trigger erzeugt. Erst in der weiter unten erläuterten Abbildungsphase werden entsprechende Trigger erzeugt, wenn die während oder am Ende der Lernphase festgelegten Merkmale oder Trigger-Bedingungen von einem jeweils zuletzt gemessenen Wert oder Signalpunkt der Atemkurve 3 erfüllt sind. Vorliegend kann die Lernphase beispielsweise fünf vollständige Atemzyklen des Patienten umfassen.

Bereits während der Lernphase wird für jeden den Messwert oder Signalpunkt der Atemkurve 3, also ein entsprechendes zugrundeliegendes zyklisches Signal, eine jeweilige Atemphase bestimmt, Anfangs- und Endzeitpunkte der einzelnen Zyklen oder Atemzyklen bestimmt, sowie entsprechende Maximal- oder Endwerte bestimmt und die mittlere Zykluslänge der erkannten Zyklen berechnet.

Dabei kann auch bereits begonnen werden, die erkannten Atemzyklen durchzuzählen oder zu nummerieren. Das Erkennen der einzelnen Atemzyklen und Atemphasen und das Durchzählen oder Nummerieren der Atemzyklen wird während des Verfahrens, also auch in der nachfolgenden Abbildungsphase bis zu einem Ende des Verfahrens fortgesetzt, was hier durch einen schleifenförmigen Pfad als Verfahrensschritt S3 gekennzeichnet ist.

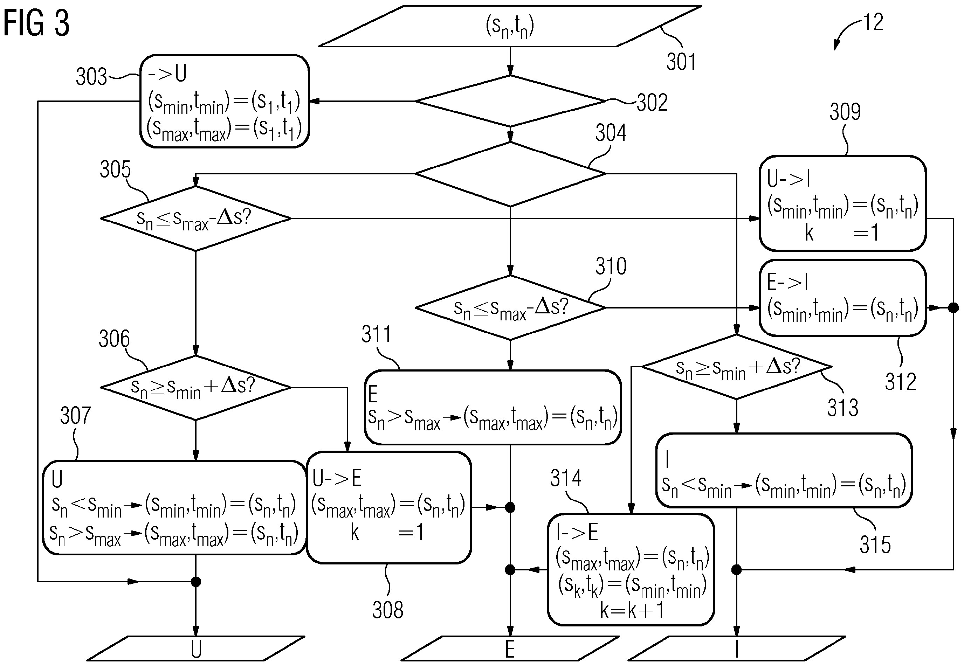

FIG 3 zeigt ein beispielhaftes schematisches Programmschema 12 zur Veranschaulichung eines Algorithmus, welcher während des Verfahrensschritts S3 zum Zuordnen einer jeweiligen Atemphase zu den Messwerten der Atemkurve 3 und zum Bestimmen des aktuellen Atemzyklus oder Atemintervalls ausgeführt werden kann. Dabei wird ferner jedem abgeschlossenen Atemzyklus ein End-Inspirationszustand, also ein Maximal- oder Endwert am Ende einer jeweiligen Ausatem-Phase und damit am Ende des jeweiligen Atemzyklus zugewiesen. Der End-Inspirationszustand ist dabei ein Tupel aus zumindest einem Signalwert und einem zugehörigen Zeitstempel, zu dem dieser Signalwert erfasst oder gemessen wurde.

Vorliegend wird eine Folge von physiologischen Signalpunkten $((s_1,t_1), (s_2,t_2),..., (s_n,t_n))$, also von Messwerten der Atemkurve 3, erfasst. Jeder Signalpunkt der Folge ist dabei ein Tupel aus einem Mess- oder Signalwert $s_n$ und einem Zeitstempel $t_n$. Die Signalwerte $s_n$ sind rauschbehaftet. Dementsprechend können die Signalwerte $s_n$ also jeweils geschrieben werden als $s_n = q_n + n_n$, wobei $q_n$ ein unbekannter tatsächlicher physiologischer Zustand, hier also die tatsächliche Position des Zwerchfells zum Zeitpunkt $t_n$, und $n_n$ ein ebenfalls unbekannter Rauschanteil ist.

Ohne Beschränkung der Allgemeinheit wird hier angenommen, dass ein lokales Maximum der Folge $(q_n)$ einem Zustand am Ende einer jeweiligen Ausatmen-Phase, also einem End-Exspirationszustand, entspricht und ein lokales Minimum der Folge $(q_n)$ einem Zustand an einem Ende einer jeweiligen Einatmen-Phase, also dem jeweiligen End-Inspirationszustand entspricht. Diese Annahme dient hier lediglich dazu, um die Beschreibung zu vereinfachen. Ist der Signalverlauf umgekehrt, können entsprechend alle Signalwerte $s_n$ mit -1 multipliziert und ansonsten das beschriebene Verfahren analog angewendet werden. Ein solcher umgekehrter Signalverlauf kann beispielsweise gegeben sein, wenn die Atemkurve 3 nicht mit einer MR-Navigatorsequenz mittels der Magnetresonanzanlage, sondern als mittels eines Atemgürtels gemessener Brustumfang des Patienten erfasst wird.

Ziel des Algorithmus ist es, die jeweils aktuelle Atemphase zu einem beliebigen Zeitpunkt $t_n$ aus den bisherigen Signalpunkten zu bestimmen, ohne die zukünftigen Signalpunkte $(s_{n+1},t_{n+1})$, $(s_{n-s},t_{n+2}),...$ zu kennen. Die Atemphase ist dabei ein Triplet, dass die Zustände "unbekannt" (U), "Ausatmen" (E), "Einatmen" (I) annehmen kann. Jedem Signalpunkt kann also als Atemphase der Wert oder Zustand U, E, oder I zugeordnet werden. Zu Beginn der jeweiligen Messung ist die Atemphase unbekannt. Sobald jedoch einmal der Zustand beziehungsweise die Atemphase "unbekannt" durch zu Zuordnen des Zustands E oder des Zustands I zu einem Signalpunkt verlassen worden ist, wird der Zustand U bis zum Ende des Verfahrens nicht mehr erreicht, also nicht mehr zugeordnet.

Wäre die Folge $(q_n)$ bekannt, wäre das Problem trivial. Aus $q_n > q_{n-1}$ könnte auf Ausatmen (Exspiration) geschlossen und aus $q_n < q_{n-1}$ auf Einatmen (Inspiration) geschlossen werden. Im Fall von $q_n = q_{n-1}$ würde der jeweilige bisherige Zustand beibehalten.

Ein weiterer Input für den Algorithmus ist ein vorgegebener Schwellenwertparameter $\Delta s$, der anschaulich ausgedrückt ein Rauschen von einer physiologisch begründeten Änderung des Signalverlaufs unterscheidet. $\Delta s$ kann beispielsweise mittels einer einmaligen Kalibrierung aus einer Standardabweichung der Folge $(s_n)$ bestimmt werden. Sofern, wie im vorliegenden Beispiel, als das zyklische Signal die Atemkurve 3 als Position des Zwerchfells mittels einer MR-Navigatorsequenz gemessen wird, kann als empirischer Wert beispielsweise $\Delta s = 4$ mm verwendet werden. Vorliegend wird $\Delta s$ jedoch in bevorzugter Weise bestimmt als

$$\Delta s = \alpha \frac{1}{M-1} \sum_{m=2}^{M} |s_m - s_{m-1}| \qquad (6)$$

wobei $\alpha$ eine mittlere Abweichung zwischen zwei aufeinanderfolgenden Signalpunkten angibt. Die Mittelung erfolgt dabei vorliegend über M während der Lernphase gemessene Signalpunkte. M ist dabei so groß gewählt, dass die Mittelung mindestens über einen kompletten Atemzyklus durchgeführt wird. Ein Wert für $\alpha$ kann vorgegeben werden und erlaubt es, den Algorithmus zu trimmen. Ein kleinerer Wert von $\alpha$ verkürzt eine Verzögerung, mit welcher eine Änderung des Atemzustandes, also der Atemphase, registriert wird. Ein größerer Wert von $\alpha$ erhöht hingegen eine Robustheit des Verfahrens gegenüber Rauschen. Empirisch hat sich beispielsweise $\alpha = 3$ als vorteilhaft erwiesen.

Der Algorithmus kann als Zustandsmaschine (FSM, englisch: "Finite State Machine") aufgefasst werden.

In einem Block 301 werden die gemessenen physiologischen Signalpunkte $(s_1,t_1)$, $(s_2,t_2),..., (s_n,t_n)$ sukzessive in der Reihenfolge, in der sie gemessen wurden, als Eingangsdaten oder Eingabewerte an den Algorithmus beziehungsweise an die Zustandsmaschine übermittelt oder bereitgestellt. In einem Block 302 wird abgefragt, ob der jeweilige Eingabewert $(s_n,t_n)$ der erste gemessene Signalpunkt ist $((s_n,t_n) = (s_1,t_1))$. Ist dies der Fall, wird in einem Block 303 diesem Eingabewert, also diesem Signalpunkt, die Atemphase U zugeordnet. Eine Variable k eines Atemzykluszählers, welcher die erkannten Atemzyklen durchzählt, also nummeriert, ist undefiniert. k kann beispielsweise mit 0 initialisiert werden. Eine Folge von End-Inspirationszuständen $(s_k,t_k)$ ist leer.

Befindet sich die Zustandsmaschine in diesem Zustand, werden ein bisher gemessener maximaler Signalwert $s_{max}$ und ein bisher gemessener minimaler Signalwerte $s_{min}$ zusammen mit den zugehörigen Zeitstempeln $t_{max}$, $t_{min}$ aufgezeichnet. Mit der Messung und Verarbeitung des ersten Signalpunktes $(s_1, t_1)$ erfolgt also die folgende Initialisierung: Atemphase = "unbekannt" (U); $(s_{min}, t_{min}) = (s_1, t_1)$; $(s_{max}, t_{max}) = (s_1, t_1)$; k = 0; Folge der End-Inspirationszustände $(s_k, t_k)$ leer.

Jede neue Messung, also jeder neuer Signalpunkt $(s_n, t_n)$ mit n > 1 (Abfrage Block 302) kann einen Übergang in den Zustand beziehungsweise in die Atemphase "Ausatmen" (E) oder "Einatmen" (I) auslösen. Dazu wird in einem Block 304 zunächst die momentane oder aktuelle Atemphase, also diejenige Atemphase, die dem vorangegangenen Signalpunkt Zugeordnet wurde, abgefragt.

Nach Verarbeiten des ersten Signalpunktes $(s_1, t_1)$ ist, wie beschrieben, die aktuelle Atemphase U. In diesem Fall wird dann in einem Block 305 für den aktuell verarbeiteten Signalpunkt $s_n$ überprüft, ob gilt

$$s_n \leq s_{max} - \Delta s \; .$$

Ist dies nicht der Fall, so wird anschließend in einem Block 306 geprüft, ob gilt

$$S_n \geq s_n + \Delta s \; .$$

Ist auch dies nicht der Fall, so bewirkt der Signalwert $s_n$ keinen Zustandsübergang, also keinen Wechsel der aktuellen Atemphase, und die aktuelle Atemphase U wird beibehalten. Zusätzlich werden in einem Block 307 die Variablen $s_{min}$, $t_{min}$ und $s_{max}$, $t_{max}$ aktualisiert:

$$s_n < s_{min} \rightarrow (s_{min}, t_{min}) = (s_n, t_n)$$

$$s_n > s_{max} \rightarrow (s_{max}, t_{max}) = (s_n, t_n) \; .$$

Ergibt hingegen die Abfrage oder Überprüfung im Block 306 ein positives Ergebnis, erfolgt in einem Block 308 ein Übergang in den Zustand "Ausatmen" (E), es wird also dem aktuell verarbeiteten Signalpunkt die Atemphase E zugeordnet. Somit ist dann also die aktuelle Atemphase E und der maximale gemessene Signalwert in dieser Atemphase wird aktualisiert zu $(s_{max}, t_{max}) = (s_n, t_n)$. $s_{max}$ ist hier eine Variable, die den maximalen Signalwert seit dem aktuellen Übergang in den Zustand E aufzeichnet, wobei $t_{max}$ der zugehörige Zeitstempel ist. Der Atemintervallzähler oder Atemzykluszähler k wir auf 1 gesetzt: k = 1.

Ergab die Abfrage oder Überprüfung im Block 305 ein positives Ergebnis, so erfolgt in einem Block 309 ein Übergang in den Zustand "Einatmen" (I) und der minimale gemessene Signalwert in dieser Atemphase wird aktualisiert zu $(s_{min}, t_{min}) = (s_n, t_n)$. $s_{min}$ ist hier eine Variable, die den minimalen Signalwert seit dem aktuellen Übergang in den Zustand "Einatmen" (I) aufzeichnet, wobei $t_{min}$ der zugehörige Zeitstempel ist. Die aktuelle und dem aktuell verarbeiteten Signalpunkt zugeordnete Atemphase ist dann also I. Der Atemintervallzähler oder Atemzykluszähler k wir auf 1 gesetzt: k = 1.

Wird hingegen im Block 304 beim Überprüfen des Zustands der Zustandsmaschine festgestellt, dass die aktuelle Atemphase "Ausatmen" (E) ist, kann mit Messung eines neuen Signalpunktes $(s_n, t_n)$ beziehungsweise mit Verarbeiten des jeweiligen aktuellen Signalpunktes $(s_n, t_n)$ entweder der Zustand E beibehalten werden oder ein Übergang in den Zustand I erfolgen. Dazu wird in einem Block 310 überprüft, ob die Bedingung

$$s_n \leq s_{max} - \Delta s$$

erfüllt ist. Ist dies nicht der Fall, so wird der aktuelle Zustand, also die aktuelle Atemphase E beibehalten und die Variablen $s_{max}$, $t_{max}$ werden aktualisiert, sofern der aktuelle Signalwerte $s_n$ größer als der aktuelle $s_{max}$, also größer als der größte Signalwert, der seit dem Übergang in den aktuellen Zustand E gemessen wurde:

$$s_n > s_{max} \rightarrow (s_{max}, t_{max}) = (s_n, t_n) \; .$$

Ergibt die Abfrage oder Überprüfung im Block 310 ein positives Ergebnis, also dass die entsprechende Bedingung erfüllt ist, erfolgt in einem Block 312 ein Übergang in den Zustand oder die Atemphase "Einatmen" (I) und die Variablen $s_{min}$, $t_{min}$ werden mit den Werten des aktuell verarbeiteten Signalwertes initialisiert: $(s_{min}, t_{min}) = (s_n, t_n)$. Die aktuelle Atemphase, die dem aktuell verarbeiteten Signalpunkt zugewiesen wird, ist dann also I.

Wird im Block 304 festgestellt, dass die aktuelle Atemphase I ist, kann mit Messung eines neuen Signalpunktes $(s_n, t_n)$ oder mit Verarbeiten des jeweils aktuellen Signalpunktes $(s_n, t_n)$ der Zustand I beibehalten werden oder ein Übergang in den Zustand E erfolgen. Dazu wird in einem Block 313 überprüft, ob die Bedingung

$$S_n \geq s_{min} + \Delta s$$

erfüllt ist. Ist dies nicht der Fall, wird sie als aktuelle Atemphase beibehalten und die Variablen $s_{min}$, $t_{min}$ werden in einem Block 315 aktualisiert, sofern der aktuelle Signalwert kleiner ist als der aktuelle Wert $s_{min}$, also als der kleinste während der aktuellen Atemphase gemessene Signalwert:

$$s_n < s_{min} \rightarrow (s_{min}, t_{min}) = (s_n, t_n) \quad .$$

Ergibt hingegen die Abfrage oder Überprüfung im Block 313 ein positives Ergebnis, erfolgt in einem Block 314 der Übergang in den Zustand oder die Atemphase E. Mit diesem Übergang werden zusätzlich im Block 314 die Variablen $s_{max}$, $t_{max}$ mit den Werten des aktuellen Signalpunktes initialisiert: $(s_{max}, t_{max}) = (s_n, t_n)$. Mit diesem Übergang ist auch das aktuelle beziehungsweise dann vorangegangene Atemintervall abgeschlossen. Deshalb wird dann der während der vergangenen Atemphase "Einatmen" aufgezeichnete minimale Signalwert $s_{min}$ zusammen mit den zugehörigen Zeitstempeln $t_{min}$ als End-Inspirationszustand des vorangegangenen Atemintervalls k als neues Element der Folge der End-Inspirationszustände abgespeichert: $(s_k, t_k) = (s_{min}, t_{min})$. Anschließend wird die Variable k, also der Atemintervallzähler, um 1 inkrementiert: k = k+1.

Auf diese Weise wird also jedem neuen Signalpunkt $(s_n, t_n)$ eindeutig ein Atemzustand, also eine Atemphase, zugewiesen. Diese Zuweisung hängt implizit über den jeweils momentanen Zustand der Zustandsmaschine und die Variablen $s_{min}$, $s_{max}$ von den zuvor gemessenen Signalpunkten ab, aber nicht von den zukünftigen Signalpunkten $(s_{n+1}, t_{n+1})$, $(s_{n+2}, t_{n+2})$,..., die bei einer prospektiven Entscheidung ja zum jeweiligen Zeitpunkt noch unbekannt sind. Sobald der Initialzustand "unbekannt" einmal verlassen ist, wird zusätzlich jedem Signalpunkt $(s_n, t_n)$ eindeutig ein Atemintervall oder Atemzyklus k zugeordnet. Jedem abgeschlossenen Atemzyklus, also den Messwerten oder Intervallen mit 1, 2,..., k-1, wird außerdem ein End-Inspirationszustand zugewiesen. Die Gesamtheit der End-Inspirationszustände bildet die Folge der End-Inspirationszustände $(s_k, t_k)$. Anhand dieser Folge kann die mittlere beziehungsweise mediane Länge oder Dauer $L_m$ der erkannten Atemzyklen sowie deren Standardabweichung $\sigma$ beziehungsweise $\tilde{\sigma}$ berechnet werden.

Es sei an dieser Stelle angemerkt, dass vorteilhaft auf eine digitale Filterung oder eine Glättung der Folge $(s_n)$ verzichtet werden kann.

Am Ende der Lernphase wird also die mittlere oder mediane Dauer $L_m$ der Atemzyklen, Atemintervalle oder Atemperioden, also der Periodendauern der Atemkurve 3, während der Lernphase bestimmt. Anschließend wird die vorgegebene Referenzrepetitionszeit $TR_{prot}$ mit der bestimmten mittleren oder medialen Dauer $L_m$ verglichen. Genauer wird die kleinste Zahl $n \geq 1$ bestimmt, welche die Ungleichung

$$(n \cdot L_m - x \cdot \sigma) > TR_{prot} \qquad (1)$$

erfüllt. Dabei ist $\sigma$ die Wurzel der mittleren quadratischen Abweichung der während der Lernphase gemessenen Atemzyklen von $L_m$ und x ein freier Parameter, mit dessen Hilfe eine Empfindlichkeit gegenüber einer Detektion eines "Short Cycle Modus" festgelegt werden kann. Typische Werte für x liegen im Bereich zwischen 0,5 und 1.

Ist die Ungleichung (1) bereits für n = 1 erfüllt, ergibt sich keine Änderung gegenüber herkömmlichen getriggerten Messverfahren und es wird in der Regel ein Trigger pro Atemzyklus erzeugt oder ausgelöst. Damit ist dann die effektive Repetitionszeit $TR_{eff}$ der Messung bei erfolgreicher Triggerung in jedem Atemzyklus gleich der mittleren Dauer $L_m$.

Ist die Ungleichung (1) hingegen nur für n > 1 erfüllt, wird nur in jedem n-ten Atemzyklus eine Triggerung zugelassen. Das bedeutet, dass dann zwischen zwei Triggern oder Trigger-Ereignissen jeweils wenigstens n-1 Atemzyklen ausgelassen werden, während derer keine Trigger erzeugt werden - und zwar auch dann nicht, wenn alle übrigen notwendigen Trigger-Bedingungen erfüllt sind. Beträgt beispielsweise n = 2, dann werden Trigger nur in jedem zweiten Atemzyklus erzeugt oder zugelassen und zwischen jeweils zwei Triggern oder Trigger-Ereignissen liegt jeweils ein kompletter Atemzyklus, während dem kein Trigger erzeugt oder ausgelöst wird. Durch dieses Auslassen eines Atemzyklus wird erreicht, dass die Zeit, die jeweils seit dem letzten Trigger vergangen ist, wenn ein neuer Trigger erzeugt oder ausgelöst wird, länger als die vorgegebene Referenzrepetitionszeit $TR_{prot}$ ist. Somit wird kein Trigger in eine suboptimale Atemphase verzögert.

Wie beschrieben liefert der Atemsensor eine Folge von physiologischen Signalpunkten $((s_1,t_1),(s_2,t_2),...,(s_n,t_n))$ bestehend aus dem jeweiligen physiologischen Signalwert $s_n$ und einem zugehörigen Zeitstempel $t_n$. Dabei ist der Signalwert $s_n$ abhängig von dem verwendeten Atemsensor in einer jeweils definierten und bekannten Weise mit der Atmung des Patienten korreliert und $t_n$ ist ein Zeitstempel, der den Zeitpunkt der Messung des Signalwertes $s_n$ angibt. Wie beschrieben kann vorliegend die Atmung des Patienten, also die Atemkurve 3, mit einem sogenannten MR-Navigator erfasst werden. Eine solcher Navigator ist eine kurze MR-Sequenz, die in eine bildgebende, also zum diagnostischen Abbilden einer Interessenregion (RoI, englisch: "Region auf Interest") dienende Sequenz, eingeschoben wird, um separat von der RoI die Atmung zu erfassen.

Ein Anregungspuls der MR-Navigatorsequenz kann beispielsweise einen zweidimensional begrenzten, stabförmigen Bereich des Patienten anregen. Dieser Bereich ist vorliegend derart auf einer Leberkuppe (englisch: "Liver dome") positioniert, dass sowohl Gewebe der Leber als auch Gewebe der Lunge angeregt wird. In einem nach diesem Anregungspuls ausgelesenen eindimensionalen Signal stellt sich die Position des Zwerchfells oder einer Zwerchfell-Kante, die sich mit der Atmung verschiebt, als Übergang zwischen hellem oder relativ starkem Signal aus der Leber und dunklem oder relativ schwachem Signal aus der Lunge dar. Die Zwerchfell-Kante lässt sich dann mit Bildverarbeitungsmethoden beispielsweise relativ zu einem vorgegebenen Referenzzustand oder Referenzbild bestimmen. $s_n$ wäre in diesem Beispiel die mit dem letzten Anregungspuls der MR-Navigatorsequenz bestimmte relative Position der Zwerchfellkante und $t_n$ wäre der Zeitpunkt, zu dem die MR-Navigatorsequenz ausgeführt wurde. Entsprechend wäre $s_{n-1}$ die mit der MR-Navigatorsequenz zuletzt oder jeweils zuvor gemessene relative Zwerchfellposition zum Zeitpunkt $t_{n-1}$ usw.

Ein Atemintervall oder Atemzyklus kann dann definiert sein als alle Signalpunkte, die zu einer Exspirations-, also Ausatem-Phase und einer darauffolgenden Inspirations- oder Einatem-Phase gehören. Die Dauer dieses Atemzyklus kann dann definiert werden als der zeitliche Abstand zwischen den Zuständen oder Signalpunkten maximaler Inspiration im aktuellen Atemzyklus und dem Zustand maximaler Inspiration, also Einatmung, im jeweils vorangegangenen Atemzyklus.

In einem Verfahrensschritt S4 wird die Abbildungsphase durchgeführt, also in mehreren Einzelmessungen der eigentliche Messdatensatz erfasst. Dabei wird in einem Verfahrensschritt S5 überprüft, ob alle Trigger-Bedingungen erfüllt sind beziehungsweise ein Trigger generiert oder ausgelöst wurde. Dies wird in einer Schleife kontinuierlich überprüft, was hier durch einen Pfad 10 angedeutet ist. Wenn alle Trigger-Bedingungen erfüllt sind, also ein Trigger generiert wurde, wird dadurch eine Einzelmessung zum Erfassen von MR-Messwerten für den Messdatensatz mittels der im Verfahrensschritt S1 ausgewählten Sequenz ausgelöst und durchgeführt.

In einem Verfahrensschritt S7 wird dann überprüft, ob mit der jeweils vorangegangenen Einzelmessung der zu akquirierende Messdatensatz vollständig ist. Ist dies nicht der Fall, folgt das Verfahren einem Pfad 11, um mit dem nächsten Trigger eine weitere Einzelmessung durchzuführen. Ist der Datensatz vollständig aufgenommen, kann das Verfahren in einem Verfahrensschritt S8 beendet werden.

Das beschriebene Verfahren ist besonders nutzbringend beispielsweise für eine T2-gewichtete Bildgebung, etwa mit einer Turbo-Spin-Echo-Sequenz (TSE), oder eine diffusionsgewichtete Bildgebung, etwa mit einer Spin-Echo Echo-Planar-Imaging-Sequenz (EPI), anwendbar, da hier eine üblicherweise gewünschte Repetitionszeit ähnlich lang ist wie ein typischer Atemzyklus.

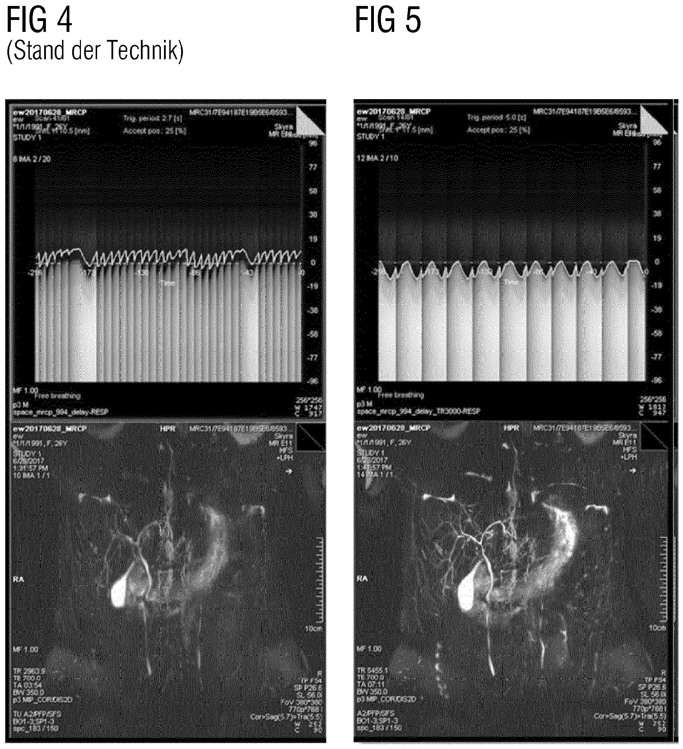

FIG 4 zeigt eine Darstellung zur Veranschaulichung einer herkömmlichen getriggerten MR-Datenakquirierung und einer resultierenden eingeschränkten Bildqualität aufgrund einer ungleichmäßigen oder unregelmäßigen effektiven Repetitionszeit $TR_{eff}$ und gegenüber jeweiligen optimalen Triggerzeitpunkten verzögerten Fehltriggern. In einem oberen Teil ist eine Atemkurve ähnlich der in FIG 1 dargestellten Atemkurve 3 abgebildet. In einem unteren Teil ist ein resultierendes rekonstruiertes MR-Bild dargestellt. In FIG 4 ist deutlich zu erkennen, dass die Triggerung in einigen Atemzyklen durch das notwendige Einhalten der vorgegebenen Referenzrepetitionszeit $TR_{prot}$ verzögert ist und in einer suboptimalen Atemphase erfolgt. Des Weiteren erfolgt unregelmäßig in einigen Atemzyklen keine Triggerung, die entsprechenden Atemzyklen werden also komplett ausgelassen, wenn jeweils nach Ablauf der vorgegebenen Referenzrepetitionszeit $TR_{prot}$ eine andere Trigger-Bedingung nicht mehr erfüllt ist. Dies führt dazu, dass die effektive Repetitionszeit $TR_{eff}$ für die bildgebende Sequenz stärker variiert als die Atemfrequenz des Patienten. Beides wirkt sich negativ auf die Bildqualität aus. Vorliegend ist die Darstellung von Gallengängen im unteren Teil trotz regelmäßiger Atmung des Patienten unscharf. In diesem Beispiel beträgt die vorgegebene Referenzrepetitionszeit $TR_{prot}$ 2400 ms und die mittlere Länge $L_m$ der Atemzyklen 2700 ms. Dies gilt ebenfalls für das in FIG 5 veranschaulichte Beispiel.

FIG 5 zeigt eine Darstellung zur Veranschaulichung einer nach dem beschriebenen verbesserten Verfahren getriggerten MR-Datenakquirierung mit einer zeitlich gleichmäßigen Triggerung im jeweils optimalen Triggerzeitpunkt, also in der jeweils optimalen Atemphase, und eine resultierende verbesserte Bildqualität. Da die vorgegebene Referenzrepetitionszeit $TR_{prot}$ hier wie in FIG 4 mit 2400 ms ähnlich lang ist wie die etwa 2700 ms lange mittlere Atemperiode, also mittlere Dauer $L_m$ der Atemzyklen, wurde hier im Vorhinein automatisch festgelegt, dass die Triggerung einer Einzelmessung nur in jedem zweiten Atemzyklus zugelassen wird. Es wird also jeweils zwischen zwei Triggern und dementsprechend jeweils zwischen zwei Einzelmessungen ein vollständiger Atemzyklus ausgelassen. Dadurch wird sichergestellt, dass die Triggerung nicht durch das Einhalten der vorgegebenen Referenzrepetitionszeit $TR_{prot}$ verzögert ist und die effektive Repetitionszeit über die gesamte Messung hinweg daher nur mit der Atemfrequenz des Patienten selbst variiert. In dem resultierenden rekonstruierten Bild sind die Gallengänge signifikant schärfer und detailreicher dargestellt als in FIG 4.

Zur Erläuterung soll hier nun noch einmal erläutert werden, was unter einer Atemtriggerung oder einer atemgetriggerten MR-Messung vorliegend zu verstehen ist. Bei der Atemtriggerung wird versucht, eine MR-Messung mit einem Atemzyklus eines frei atmenden Patienten zu synchronisieren und das Akquirieren von MR-Messdaten bevorzugt auf eine relativ ruhige Atemphase des Atemzyklus am Ende der Exspiration, also am Ende des Ausatmens (englisch: "end expiration") zu beschränken. Dazu wird die Atmung des Patienten als zyklisches, physiologisches Signal erfasst. Nach der anfänglichen Lernphase des Triggeralgorithmus wird ein Trigger erzeugt, sobald ein vorbestimmtes Trigger-Ereignis eingetreten oder alle notwendigen vorgegebenen Trigger-Bedingungen erfüllt sind, zum Beispiel eine bestimmte Atemphase des Atemzyklus oder ein bestimmter Punkt innerhalb des Atemzyklus oder innerhalb einer bestimmten Atemphase, detektiert oder erreicht wird. In Folge des Triggers akquiriert die Magnetresonanzanlage mittels der vorgegebenen bildgebenden MR-Sequenz einen wiederum vorbestimmten Teil des insgesamt zu akquirierenden Datensatzes von einer oder mehreren Schichten.

Nachdem dieser vorbestimmte Teil, also ein bestimmtes Datenpaket, akquiriert ist, stoppt die bildgebende Datenakquisition automatisch bis der Triggeralgorithmus den nächsten Trigger generiert. Daraufhin wird der nächste Teil des Datensatzes, also das nächste Datensatz, mittels der bildgebenden MR-Sequenz akquiriert. Dieser Ablauf wird solange fortgeführt, bis alle Daten für den gesamten Datensatz von allen Schichten akquiriert sind.

Bevorzugt werden die Trigger-Bedingungen derart gewählt oder festgelegt, dass Trigger während der Ausatmung erzeugt werden und derart, dass die Datenakquisition auf die relativ ruhige Phase des Atemzyklus am Ende der Exspiration beschränkt wird. Bevorzugt wird maximal ein Trigger pro Atemzyklus erzeugt. Eine atemgetriggerten MR-Sequenz akquiriert demnach höchstens einmal pro Atemzyklus Daten einer bestimmten Schicht. Bei Sequenzen, bei denen diese Datenakquisition nach je einem Anregungspuls erfolgt, ist die Repetitionszeit (TR), also die Zeit zwischen zwei Anregungen der gleichen Schicht, nicht fix, sondern variiert mit dem Atemzyklus, also der Atemfrequenz, des Patienten. Die Repetitionszeit TR ist ein wichtiger Parameter in der Magnetresonanz-Bildgebung, da hierdurch ein Kontrast eines resultierenden Bildes maßgeblich bestimmt wird. In der atemgetriggerten Magnetresonanz-Bildgebung spricht man unter den genannten Voraussetzungen von einer effektiven Repetitionszeit ($TR_{eff}$), die gleich der mittleren Länge $L_m$ der Atemzyklen des Patienten ist. Die Länge einzelner Atemzyklen des Patienten kann signifikanten individuellen, gegebenenfalls krankheitsbedingten, Schwankungen unterliegen und typischerweise zwischen 3 s und 6 s betragen.

Insgesamt zeigen die beschriebenen Beispiele, wie eine verbesserte Bildqualität bei besonders einfacher Nutzbarkeit für eine getriggerten Datenakquisition erreicht werden kann.

## Patentansprüche

1. Verfahren (9) zum getriggerten Akquirieren eines Messdatensatzes eines Zielobjekts in mehreren Einzelmessungen mittels einer Magnetresonanzanlage, mit den Verfahrensschritten

- Erfassen eines zyklischen Signals (3), welches eine zyklische Veränderung zumindest eines Teils des Zielobjekts beschreibt,
- fortgesetztes automatisches Erkennen von Zyklen des zyklischen Signals (3),
- automatisches Bestimmen einer mittleren Dauer $L_m$ der erkannten Zyklen als wenigstens eine Eigenschaft des zyklischen Signals (3),
- Vorgeben einer Referenzzeitdauer $TR_{prot}$ als ein Referenzwert eines Akquisitionsparameters,
**dadurch gekennzeichnet, dass** die folgenden Verfahrensschritte durchgeführt werden
- automatisches Festlegen, ob in einem bestimmten erkannten Zyklus des zyklischen Signals (3) ein Triggern einer der Einzelmessungen zugelassen wird, in Abhängigkeit von der mittleren Dauer $L_m$ und der Referenzzeitdauer $TR_{prot}$, wobei die kleinste ganze Zahl $n \geq 1$ bestimmt wird, sodass ein n-faches der bestimmten mittleren Dauer $L_m$ länger ist als die vorgegebene Referenzzeitdauer $TR_{prot}$, und
- Akquirieren des Messdatensatzes des Zielobjekts in mehreren Einzelmessungen, wobei das Triggern der Einzelmessungen nur in jedem n-ten Zyklus des zyklischen Signals (3) zugelassen wird.

2. Verfahren (9) nach Anspruch 1, **dadurch gekennzeichnet, dass** als notwendige Bedingung zum Triggern der Einzelmessungen ein Zykluspunkt (7) festgelegt wird, den das zyklische Signal (3) in einem Zyklus jeweils erreicht haben muss.

3. Verfahren (9) nach Anspruch 1 oder 2, **dadurch gekennzeichnet, dass**

- die empirische Standardabweichung σ der Dauern der erkannten Zyklen des zyklischen Signals (3) bestimmt wird, und
- die Zahl n so bestimmt wird, dass die Bedingung

$$(n \cdot L_m - x \cdot \sigma) > TR_{prot} \qquad (1)$$

erfüllt ist, wobei x ein freier Parameter mit einem vorgegebenen Wert ist.

4. Verfahren nach Anspruch 3, **dadurch gekennzeichnet, dass** der Wert des freien Parameters x aus dem Intervall 0,5 bis 2, bevorzugt aus dem Intervall 0,5 bis 1, vorgegeben wird.

5. Verfahren (9) nach einem der Ansprüche 1 bis 4, **dadurch gekennzeichnet, dass**

- die erkannten Zyklen mit einer fortlaufenden Zyklusnummer k durchnummeriert werden,
- jedem erfassten Messwert s des zyklischen Signals (3) eine der Zyklusnummern k zugeordnet wird,
- für jeden der erkannten, nummerierten Zyklen ein Maximalwert, insbesondere ein Endwert ($s_{max}$), des zyklischen Signals (3) bestimmt wird, und daraus eine Folge der Maximalwerte (($s_k, t_k$)) erzeugt wird.

6. Verfahren (9) nach einem der vorhergehenden Ansprüche, **dadurch gekennzeichnet, dass**

- als eine weitere Eigenschaft des zyklischen Signals bestimmt wird, zu welchem Zeitpunkt $t_n$ in dem jeweiligen bestimmten Zyklus erstmalig ein erfasster Messwert des zyklischen Signals (3) einen vorgegebenen Schwellenwert überschreitet oder in einem bestimmten Werteintervall (4) liegt,
- das Triggern in dem jeweiligen bestimmten Zyklus nur dann zugelassen wird, wenn zwischen der jeweils vorausgegangenen Einzelmessung und dem Zeitpunkt $t_n$ wenigstens die Referenzzeitdauer $TR_{prot}$ vergangen ist.

7. Verfahren (9) nach einem der vorhergehenden Ansprüche, **dadurch gekennzeichnet, dass**

- als eine weitere Eigenschaft des zyklischen Signals bestimmt wird, zu welchem Zeitpunkt $t_n$ in dem jeweiligen bestimmten Zyklus erstmalig ein erfasster Wert des zyklischen Signals (3) einen vorgegebenen Schwellenwert überschreitet oder in einem bestimmten Werteintervall (4) liegt,
- als ein weiterer Referenzwert ein maximaler SAR-Wert $SAR_{max}$ vorgegeben wird für wenigstens ein vorgegebenes Zeitintervall, welches den Zeitpunkt $t_n$ einschließt, und
- das Triggern in dem jeweiligen bestimmten Zyklus nur dann zugelassen wird, falls durch eine zum Zeitpunkt $t_n$ getriggerte Einzelmessung der vorgegebene maximale SAR-Wert $SAR_{max}$ nicht überschritten würde.

8. Verfahren (9) nach einem der vorhergehenden Ansprüche, **dadurch gekennzeichnet, dass** die Einzelmessungen jeweils kürzer als die mittlere Dauer $L_m$ der erkannten Zyklen (3) sind.

9. Verfahren (9) nach einem der vorhergehenden Ansprüche, **dadurch gekennzeichnet, dass** als das zyklische Signal (3) ein Herzschlag erfasst wird.

10. Verfahren (9) nach einem der vorhergehenden Ansprüche, **dadurch gekennzeichnet, dass** als das zyklische Signal (3) eine Atemkurve (3) erfasst wird.

11. Verfahren (9) nach Anspruch 10, **dadurch gekennzeichnet, dass**

- automatisch unterschiedliche Phasen (E, I) der Atemkurve (3), insbesondere die Phase "Einatmen" (I) und die Phase "Ausatmen" (E), erkannt werden, und
- das Triggern einer der Einzelmessungen nur während der Phase "Ausatmen" (E) zugelassen wird.

12. Magnetresonanzanlage zum getriggerten Akquirieren eines Messdatensatzes eines Zielobjekts in mehreren Einzelmessungen mit

- einer Erfassungseinrichtung zum Erfassen eines zyklischen Signals (3), welches eine zyklische Veränderung zumindest eines Teils des Zielobjekts beschreibt,
- einer Messeinrichtung zum Akquirieren des Messdatensatzes,
- einer Datenverarbeitungseinrichtung, umfassend einen Datenspeicher und eine mit diesem verbundene Prozessoreinrichtung die dazu ausgelegt ist, das Verfahren nach einem der Ansprüche 1-11 auszuführen.

13. Computerprogramm, umfassend Befehle, die bewirken, dass die Magnetresonanzanlage nach Anspruch 12 die Verfahrensschritte eines Verfahrens nach einem der Ansprüche 1 bis 11 ausführt.

14. Datenspeicher für eine Magnetresonanzanlage, wobei in dem Datenspeicher ein Programmcode gespeichert ist, welcher zumindest ein Computerprogramm nach Anspruch 13 umfasst.

**Claims**

1. Method (9) for triggered acquisition of a measured data set of a target object in a plurality of single measurements by means of a magnetic resonance system, having the following method steps:

   - detecting a cyclical signal (3), which describes a cyclical change in at least part of the target object,
   - continued automatic identification of cycles of the cyclical signal (3),
   - automatic determination of a mean duration $L_m$ of the identified cycles as at least one property of the cyclical signal (3),
   - specification of a reference duration $TR_{prot}$ as a reference value of an acquisition parameter,
   **characterised in that**, the following method steps are carried out
   - automatic determination of whether, in a particular identified cycle of the cyclical signal (3), triggering of one of the single measurements is permitted, as a function of the mean duration $L_m$ and the reference duration $TR_{prot}$, wherein the smallest whole number $n \geq 1$ is determined, so an n-multiple of the determined mean duration $L_m$ is longer than the specified reference duration $TR_{prot}$, and
   - acquisition of the measured data set of the target object in a plurality of single measurements, wherein triggering of the single measurements is permitted only in each $n^{th}$ cycle of the cyclical signal (3).

2. Method (9) according to claim 1, **characterised in that** as a necessary condition for triggering of the single measurements, a cycle point (7) is defined which the cyclical signal (3) has to have reached in one cycle respectively.

3. Method (9) according to claim 1 or 2, **characterised in that**

   - the empirical standard deviation $\sigma$ of the durations of the identified cycles of the cyclical signal (3) is determined, and
   - the number n is determined such that the condition

$$(n \cdot L_m - x \cdot \sigma) > TR_{prot} \qquad (1)$$

   is met, where x is a free parameter having a specified value.

4. Method according to claim 3, **characterised in that** the value of the free parameter x is specified from the interval 0.5 to 2, preferably from the interval 0.5 to 1.

5. Method (9) according to one of claims 1 to 4, **characterised in that**

   - the identified cycles are consecutively numbered with a consecutive cycle number k,
   - one of the cycle numbers k is allocated to each acquired measured value s of the cyclical signal (3),
   - a maximum value, in particular an end value ($s_{max}$), of the cyclical signal (3) is determined, and from this a sequence of maximum values (($s_k,t_k$)) is generated for each of the identified, numbered cycles.

6. Method (9) according to one of the preceding claims, **characterised in that**

   - as a further property of the cyclical signal it is determined at which instant $t_n$ in the respective determined cycle an acquired measured value of the cyclical signal (3) exceeds a specified threshold value or lies in a particular value interval (4) for the first time,

- triggering in the respective determined cycle is permitted only when at least the reference duration $TR_{prot}$ has elapsed between the preceding single measurement and the instant $t_n$ in each case.

7. Method (9) according to one of the preceding claims, **characterised in that**

- as a further property of the cyclical signal it is determined at which instant $t_n$ in the respective determined cycle an acquired value of the cyclical signal (3) exceeds a specified threshold value or lies in a particular value interval (4) for the first time,
- a maximum SAR value $SAR_{max}$ is specified as a further reference value for at least one specified time interval, which includes the instant $t_n$, and
- triggering in the respective determined cycle is permitted only if the specified maximum SAR value $SAR_{max}$ would not be exceeded by a single measurement triggered at instant $t_n$.

8. Method (9) according to one of the preceding claims, **characterised in that** the single measurements are each shorter than the mean duration $L_m$ of the identified cycles (3).

9. Method (9) according to one of the preceding claims, **characterised in that** a heartbeat is detected as the cyclical signal (3).

10. Method (9) according to one of the preceding claims, **characterised in that** a respiration curve (3) is detected as the cyclical signal (3).

11. Method (9) according to claim 10, **characterised in that**

- different phases (E, I) of the respiration curve (3), in particular the "inhalation" (I) phase and the "exhalation" phase (E), are automatically identified, and
- triggering of one of the single measurements is permitted only during the "exhalation" (E) phase.

12. Magnetic resonance system for triggered acquisition of a measured data set of a target object in a plurality of single measurements having:

- a detection device for detecting a cyclical signal (3), which describes a cyclical change in at least part of the target object,
- a measuring device for the acquisition of the measured data set,
- a data processing device, comprising a data memory and a processor device connected thereto which is configured for carrying out the method according to one of claims 1-11.

13. Computer program, comprising commands which cause the magnetic resonance system according to claim 12 to carry out the method steps of a method according to one of claims 1 to 11.

14. Data memory for a magnetic resonance system, wherein a program code is stored in the data memory, which comprises at least one computer program according to claim 13.

**Revendications**

1. Procédé (9) d'acquisition déclenchée d'un ensemble de données de mesure d'un objet cible en plusieurs mesures individuelles, au moyen d'une installation de résonance magnétique, comprenant les stades de procédé

- détection d'un signal (3) cyclique, qui décrit une variation cyclique d'au moins une partie de l'objet cible,
- identification automatique continue de cycles du signal (3) cyclique,
- détermination automatique d'une durée $L_m$ moyenne des cycles identifiés comme au moins une propriété du signal (3) cyclique,
- prescription d'une durée $TR_{prot}$ de temps de référence comme valeur de référence d'un paramètre d'acquisition, **caractérisé en ce que** l'on effectue les stades de procédé suivants
- détermination automatique du point de savoir, si dans un cycle identifié déterminé du signal (3) cyclique est autorisé un déclenchement de l'une des mesures individuelles, en fonction de la durée $L_m$ moyenne et de la durée $TR_{prot}$ de temps de référence, dans lequel on détermine le nombre entier le plus petit n ≥ 1, de manière à ce que n fois la durée $L_m$ moyenne déterminée soit plus longue que la durée $TR_{prot}$ de temps de référence prescrite, et

- acquisition de l'ensemble de données de mesure de l'objet cible en plusieurs mesures individuelles, dans lequel le déclenchement des mesures individuelles n'est autorisé que dans chaque énième cycle du signal (3) cyclique.

2. Procédé (9) suivant la revendication 1, **caractérisé en ce que** l'on fixe comme condition nécessaire au déclenchement des mesures individuelles, un point (7) du cycle que le signal (3) cyclique doit avoir atteint respectivement dans un cycle.

3. Procédé (9) suivant la revendication 1 ou 2, **caractérisé en ce que** l'

- on détermine l'écart-type σ empirique des durées des cycles identifiés du signal (3) cyclique, et
- on détermine le nombre n, de manière à satisfaire la condition

$$(n \cdot L_m - x \cdot \sigma) > TR_{prot} \qquad (1)$$

dans laquelle x est un paramètre libre ayant une valeur prescrite.

4. Procédé (9) suivant la revendication 3, **caractérisé en ce que** l'on prescrit la valeur du paramètre x libre dans l'intervalle de 0,5 à 2, de préférence dans l'intervalle de 0,5 à 1.

5. Procédé (9) suivant l'une des revendications 1 à 4, **caractérisé en ce que** l'

- on numérise les cycles identifiés par un numéro k de cycle continu,
- on affecte un numéro k de cycle à chaque valeur s de mesure détectée du signal (3) cyclique,
- on détermine, pour chacun des cycles numérisés identifiés, une valeur maximum, en particulier une valeur $(s_{max})$ finale, du signal (3) cyclique et on en produit une suite des valeurs $((s_k, t_k))$ maximums.

6. Procédé (9) suivant l'une des revendications précédentes, **caractérisé en ce que** l'

- on détermine, comme autre propriété du signal cyclique, l'instant $t_n$ dans le cycle déterminé respectif, où pour la première fois une valeur détectée du signal (3) cyclique dépasse une valeur de seuil prescrite ou se trouve dans un intervalle (4) de valeur déterminée,
- on n'autorise le déclenchement dans le cycle déterminé respectif, que s'il s'est écoulé au moins la durée $TR_{prot}$ de temps de référence entre la mesure individuelle précédente respectivement et l'instant $t_n$.

7. Procédé (9) suivant l'une des revendications précédentes, **caractérisé en ce que** l'

- on détermine comme autre propriété du signal cyclique, l'instant $t_n$ dans le cycle déterminé respectif, où pour la première fois une valeur détectée du signal (3) cyclique dépasse une valeur de seuil prescrite ou se trouve dans un intervalle (4) de valeur déterminée,
- on prescrit comme autre valeur de référence une valeur SAR $SAR_{max}$ maximum pendant au moins un intervalle de temps prescrit, qui inclut l'instant $t_n$, et
- on n'autorise le déclenchement dans le cycle déterminé respectif, que si, par une mesure individuelle déclenchée à l'instant $t_n$, la valeur SAR $SAR_{max}$ maximum prescrite ne serait pas dépassée.

8. Procédé (9) suivant l'une des revendications précédentes, **caractérisé en ce que** les mesures individuelles sont chacune, plus brèves que la durée $L_m$ moyenne des cycles (3) identifiés.

9. Procédé (9) suivant l'une des revendications précédentes, **caractérisé en ce que** l'on détecte un battement du cœur comme signal (3) cyclique.

10. Procédé (9) suivant l'une des revendications précédentes, **caractérisé en ce que** l'on détecte une courbe (3) de respiration comme signal (3) cyclique.

**11.** Procédé (9) suivant la revendication 10, **caractérisé en ce que** l'

- on identifie automatiquement des phases (E, I) différentes de la courbe (3) de respiration, en particulier la phase "inspiration" (I) et la phase "expiration" (E), et
- on n'autorise le déclenchement de l'une des mesures individuelles que pendant la phase "expiration" (E).

**12.** Installation de résonance magnétique pour l'acquisition déclenchée d'un ensemble de données de mesure d'un objet cible en plusieurs mesures individuelles, comprenant

- un dispositif de détection pour la détection d'un signal (3) cyclique, qui décrit une variation cyclique d'au moins une partie de l'objet cible,
- un dispositif de mesure pour l'acquisition de l'ensemble de données de mesure,
- un dispositif de traitement de données, comprenant une mémoire de données et un dispositif à processeur relié à celle-ci, et conçu pour exécuter un procédé suivant l'une des revendications 1 à 11.

**13.** Programme d'ordinateur, comprenant des instructions, qui font que l'installation de résonance magnétique suivant la revendication 12 exécute les stades d'un procédé suivant l'une des revendications 1 à 11.

**14.** Mémoire de données pour une installation de résonance magnétique, dans lequel il est mis en mémoire dans la mémoire de données, un code de programme, qui comprend au moins un programme d'ordinateur suivant la revendication 13.

FIG 1(Stand der Technik)

FIG 2

FIG 3

# FIG 4
## (Stand der Technik)

# FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102016208094 A1
- DE 102009061198 B3

- DE 102009055960 A1